(19) Europäisches Patentamt
European Patent Office
Office européen des brevets

(11) EP 4 080 130 A1

(12) EUROPEAN PATENT APPLICATION
published in accordance with Art. 153(4) EPC

(43) Date of publication:
**26.10.2022 Bulletin 2022/43**

(21) Application number: **20914704.0**

(22) Date of filing: **17.01.2020**

(51) International Patent Classification (IPC):
***F24F 11/63** (2018.01)*

(52) Cooperative Patent Classification (CPC):
F24F 11/63

(86) International application number:
**PCT/JP2020/001492**

(87) International publication number:
**WO 2021/144958 (22.07.2021 Gazette 2021/29)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **MITSUBISHI ELECTRIC CORPORATION**
**Chiyoda-ku**
**Tokyo 100-8310 (JP)**

(72) Inventors:
- **FURUKI, Ichiro**
  **Tokyo 100-8310 (JP)**
- **SAITO, Keita**
  **Tokyo 100-8310 (JP)**

(74) Representative: **Pfenning, Meinig & Partner mbB**
**Patent- und Rechtsanwälte**
**Theresienhöhe 11a**
**80339 München (DE)**

# (54) INFORMATION PROCESSING DEVICE, INFORMATION PROCESSING METHOD, AND INFORMATION PROCESSING PROGRAM

(57) A Voronoi-partition processing unit (105) performs Voronoi partition on a plane region of a space where a plurality of air conditioners are placed, treating as a seed point, a position where each of the plurality of air conditioners is placed, and generates a plurality of partition regions each of which includes any of the plurality of air conditioners. A region correction unit (106) adjusts an area of at least one of the plurality of partition regions based on air-conditioning performance of each of the plurality of air conditioners.

Fig. 2

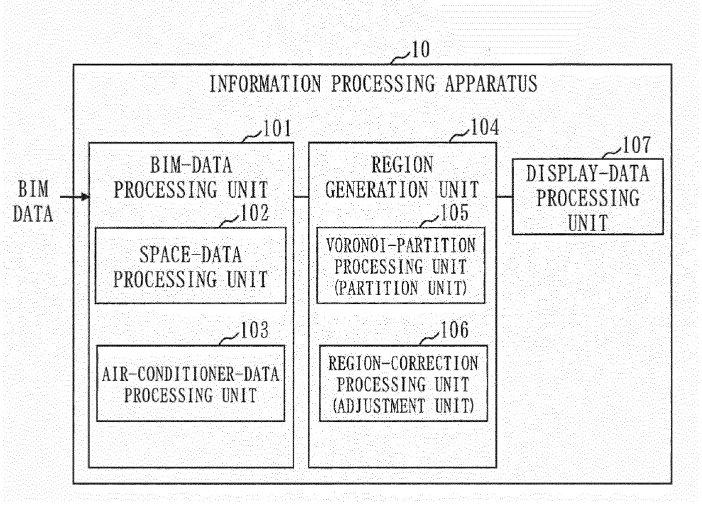




Processed by Luminess, 75001 PARIS (FR)

## Description

### Technical Field

The present disclosure relates to air conditioning by air conditioners.

### Background Art

Patent Literature 1 discloses a technique of calculating a heat load of an air conditioner. Specifically, the technique of Patent Literature 1 acquires data necessary for heat load calculation from BIM (Building Information Modeling) data and performs the heat load calculation for each space where the air conditioning is performed. When a plurality of air conditioners are placed in a large space, in order to calculate the heat load of each of the air conditioners more finely, it is necessary to perform the heat load calculation in a unit of a range (hereinafter, referred to as an air-conditioner zone) which the air conditioner covers. However, information on the air-conditioner zones is not included in general BIM data.

Patent Literature 2 discloses a method of acquiring the air-conditioner zone for each air conditioner based on the BIM data. Specifically, a technique of Patent Literature 2 takes from the BIM data, a shape of a space inside a building and position information on the air conditioners, and performs Voronoi partition, treating positions of the air conditioners as seed points. Then, the technique of Patent Literature 2 generates for each seed point, a rectangle which circumscribes an inscribed circle with a closest Voronoi boundary line, and acquires the air-conditioner zone for each air conditioner based on the rectangle.

### Citation List

### Patent Literature

Patent Literature 1: WO2017/212563A
Patent Literature 2: WO2017/046875A

### Summary of Invention

### Technical Problem

When a plurality of air conditioners are placed in a space and there is a difference in air-conditioning performance between the air conditioners, it is desirable to reflect the difference in the air-conditioning performance on the air-conditioner zones in order to perform accurate heat load calculation.

However, there is a problem that the technique of Patent Literature 2 cannot perform the accurate heat load calculation which reflects the difference in the air-conditioning performance between the air conditioners, since the difference in the air-conditioning performance between the air conditioners is not reflected on the air-conditioner zones.

One of main objects of the present disclosure is to solve an above-described problem. More specifically, the present disclosure mainly aims to realize accurate heat load calculation which reflects a difference in air-conditioning performance between air conditioners .

### Solution to Problem

An information processing apparatus according to the present disclosure includes:

a partition unit to perform Voronoi partition on a plane region of a space where a plurality of air conditioners are placed, treating as a seed point, a position where each of the plurality of air conditioners is placed, and generate a plurality of partition regions each of which includes any of the plurality of air conditioners; and
an adjustment unit to adjust an area of at least one of the plurality of partition regions based on air-conditioning performance of each of the plurality of air conditioners.

### Advantageous Effects of Invention

According to the present disclosure, it is possible to realize accurate heat load calculation which reflects a difference in air-conditioning performance between air conditioners.

## Brief Description of Drawings

Fig. 1 is a diagram illustrating a hardware configuration example of an information processing apparatus according to a first embodiment.
Fig. 2 is a diagram illustrating a functional configuration example of the information processing apparatus according to the first embodiment.
Fig. 3 is a diagram illustrating an example of an air-conditioning space and a placement example of air conditioners according to the first embodiment.
Fig. 4 is a diagram illustrating an example of Voronoi partition according to the first embodiment.
Fig. 5 is a flowchart illustrating an operation example of the information processing apparatus according to the first embodiment.
Fig. 6 is a flowchart illustrating a procedure of calculating a parallel translation amount of a boundary line according to the first embodiment.
Fig. 7 is a flowchart illustrating a procedure of calculating the parallel translation amount of the boundary line according to the first embodiment.
Fig. 8 is a diagram illustrating a procedure of translating the boundary lines according to the first embodiment.
Fig. 9 is a diagram illustrating the procedure of translating the boundary lines according to the first embodiment.
Fig. 10 is a diagram illustrating the procedure of translating the boundary lines according to the first embodiment.
Fig. 11 is a diagram illustrating an example of an air-conditioning space and a placement example of air conditioners according to a second embodiment.
Fig. 12 is a diagram illustrating an example of Voronoi partition according to the second embodiment.
Fig. 13 is a flowchart illustrating an operation example of an information processing apparatus according to the second embodiment.
Fig. 14 is a flowchart illustrating details of step ST400 according to the second embodiment.

## Description of Embodiments

Hereinafter, embodiments will be described with reference to the drawings. In the following description of the embodiments and the drawings, parts assigned by the same reference numerals indicate the same parts or corresponding parts.

First Embodiment.

*** Description of Configuration ***

Fig. 1 illustrates a hardware configuration example of an information processing apparatus 10 according to the present embodiment.

The information processing apparatus 10 according to the present embodiment is a computer. An operation procedure of the information processing apparatus 10 is equivalent to an information processing method. Also, a program which realizes operation of the information processing apparatus 10 is equivalent to an information processing program.

The information processing apparatus 10 includes as pieces of hardware, a processor 11, a main storage device 12, an auxiliary storage device 13, a device interface 14, a communication interface 15, and a display device 16.

The auxiliary storage device 13 stores programs which realize functions of a BIM-data processing unit 101, a region generation unit 104, and a display-data processing unit 107 which will be described later. These programs are loaded from the auxiliary storage device 13 into the main storage device 12. Then, the processor 11 executes these programs.

Fig. 1 schematically illustrates a state where the processor 11 executes the programs which realize the functions of the BIM-data processing unit 101, the region generation unit 104, and the display-data processing unit 107.

Fig. 2 illustrates a functional configuration example of the information processing apparatus 10 according to the present embodiment.

The information processing apparatus 10 according to the present embodiment is configured with the BIM-data processing unit 101, the region generation unit 104, and the display-data processing unit 107.

The BIM-data processing unit 101 acquires BIM data.

The BIM-data processing unit 101 has a space-data processing unit 102 and an air-conditioner-data processing unit 103 as an internal configuration.

The space-data processing unit 102 acquires from the BIM data, shape data of a space (hereinafter, referred to as an air-conditioning space) where air conditioning is performed. Note that, a plurality of air conditioners are placed in the air-conditioning space.

The air-conditioner-data processing unit 103 acquires air-conditioner position data and air-conditioner performance data from the BIM data. The air-conditioner position data indicates a position of each of the plurality of air conditioners placed in the air-conditioning space. The air-conditioner performance data indicates air-conditioning performance of each of the plurality of air conditioners placed in the air-conditioning space. The air-conditioning performance is cooling performance or/and heating performance. The air-conditioner position data and the air-conditioner performance data are collectively referred to as air-conditioner data.

The shape data of the air-conditioning space and the air-conditioner data are output to the region generation unit 104.

The region generation unit 104 generates a plurality of partition regions in the air-conditioning space.

The region generation unit 104 has a Voronoi-partition processing unit 105 and a region correction unit 106 as an internal configuration.

The Voronoi-partition processing unit 105 performs Voronoi partition on the air-conditioning space, treating as a seed point, a position where each of the plurality of air conditioners is placed. Then, the Voronoi-partition processing unit 105 generates the plurality of partition regions each of which includes one of the plurality of air conditioners. The Voronoi-partition processing unit 105 is equivalent to a partition unit. Also, a process performed by the Voronoi-partition processing unit 105 is equivalent to a partition process.

The region correction unit 106 adjusts an area of at least one of the plurality of partition regions based on the air-conditioning performance of each of the plurality of air conditioners. The region correction unit 106 adjusts the area of at least one of the plurality of partition regions by translating a Voronoi boundary line in parallel. In the present embodiment, the partition region which has been adjusted by the region correction unit 106 is equivalent to the air-conditioner zone. The region correction unit 106 is equivalent to an adjustment unit. Further, a process performed by the region correction unit 106 is equivalent to an adjustment process.

The display-data processing unit 107 generates display data indicating the air-conditioner zone of each air conditioner, and outputs the generated display data to the display device 16.

*** Description of Operation ***

Next, with reference to a flowchart of Fig. 5, an outline of operation of the information processing apparatus 10 according to the present embodiment will be described.

Note that, the BIM data is assumed to be stored in the main storage device 12 before a procedure illustrated in Fig. 5 starts.

For example, the BIM data is stored in the main storage device 12 by connecting an outside storage device 17 storing the BIM data to the device interface 14. Note that, as a means of storing the BIM data in the main storage device 12, a computer terminal or a mobile terminal may be used. Alternatively, the BIM data may be stored in the main storage device 12 via a network by connecting the communication interface 15 to a wired network or a wireless network.

Then, the BIM-data processing unit 101 acquires the BIM data from the main storage device 12.

After the BIM data is acquired from the main storage device 12, first, the space-data processing unit 102 acquires the shape data of the air-conditioning space from the BIM data (step ST201).

Further, the air-conditioner-data processing unit 103 acquires the air-conditioner data (the air-conditioner position data and the air-conditioner performance data) from the BIM data (step ST201).

The shape data of the air-conditioning space and the air-conditioner data are output to the region generation unit 104.

Note that, in the present embodiment, descriptions are given on an assumption of an air-conditioning space 201 indicated in Fig. 3. Fig. 3 indicates a plane region (ceiling region) of the air-conditioning space 201. That is, in the air-conditioning space 201, air conditioners AC1, AC2, AC3, and AC4 are assumed to be placed at positions illustrated in Fig. 3. Dashed lines of Fig. 3 are straight lines connecting each air conditioner. A line segment X12 is a straight line connecting the air conditioners AC 1 and AC2. A line segment X13 is a straight line connecting the air conditioners AC1 and AC3. A line segment X24 is a straight line connecting the air conditioners AC2 and AC4. A line segment X34 is a straight line connecting the air conditioners AC3 and AC4.

Further, the air-conditioning performance of each of the air conditioners AC1, AC2, AC3, and AC4 is written as P1, P2, P3, and P4, respectively.

In the present embodiment, the space-data processing unit 102 acquires the shape data indicating a shape of the plane region of the air-conditioning space 201. Further, the air-conditioner-data processing unit 103 acquires the air-conditioner position data indicating a position of each of the air conditioners AC1, AC2, AC3, and AC4 and the air-conditioner performance data indicating each of the air-conditioning performance P1, P2, P3, and P4.

Next, in the region generation unit 104, the Voronoi-partition processing unit 105 performs the Voronoi partition on the plane region of the air-conditioning space 201 (step ST203)

The Voronoi partition is a method of specifying, when a plurality of seed points exist on a plane, the closest seed point for each seed point and partitioning the plane by a boundary line dividing into halves, a straight line between each seed point and its closest seed point. The boundary line acquired by the Voronoi partition is referred to as a Voronoi boundary line.

The partition regions obtained by performing the Voronoi-partition on the air-conditioning space 201 illustrated in Fig. 3 are illustrated in Fig. 4.

Fig. 4 illustrates the partition regions obtained by performing the Voronoi partition on the air-conditioning space 201, treating the positions of the air conditioners AC1, AC2, AC3, and AC4 as the seed points.

A partition region r1 is a partition region which includes the air conditioner AC1. The partition region r1 is partitioned by a boundary line b12 and a boundary line b13. The boundary line b12 is a boundary line dividing into halves, a straight line (line segment X12) between the air conditioner AC1 and the air conditioner AC2. The boundary line b13 is a boundary line dividing into halves, a straight line (line segment X13) between the air conditioner AC1 and the air conditioner AC3.

A partition region r2 is a partition region which includes the air conditioner AC2. The partition region r2 is partitioned by the boundary line b12 and a boundary line b24. The boundary line b24 is a boundary line dividing into halves, a straight line (line segment X24) between the air conditioner AC2 and the air conditioner AC4.

A partition region r3 is a partition region which includes the air conditioner AC3. The partition region r3 is partitioned by the boundary line b13 and a boundary line b34. The boundary line b34 is a boundary line dividing into halves, a straight line (line segment X34) between the air conditioner AC3 and the air conditioner AC4.

A partition region r4 is a partition region which includes the air conditioner AC4. The partition region r4 is partitioned by the boundary line b24 and the boundary line b34.

Next, the region correction unit 106 calculates a performance proportional-distribution area $A_i$ (step ST204).

The performance proportional-distribution area Ai is an area corresponding to the air-conditioning performance of each air conditioner.

A subscript i is a number given to each air conditioner placed in the air-conditioning space 201. A maximum value of the subscript i is the number of air conditioners placed in the air-conditioning space 201. In an example of Fig. 3, since the air conditioners AC1, AC2, AC3, and AC4 exist, the subscript i is from one to four. Therefore, the respective responsible-region areas Ai are $A_1$, $A_2$, $A_3$, and $A_4$.

The region correction unit 106 obtains the performance proportional-distribution area $A_i$ according to an equation 1.

[formula 1]

$$Ai = \frac{Pi}{\Sigma P} R \quad \text{(equation 1)}$$

Note that, in the equation 1, Pi is the air-conditioning performance of the air conditioner i. R is a total area of the air-conditioning space 201. ΣP is a total of air-conditioning performance Pi of all of the air conditioners which exist in the air-conditioning space 201.

As described above, the region correction unit 106 calculates for each air conditioner, the performance proportional-distribution area Ai by multiplying by the total area (R) of the air-conditioning space 201, a ratio (Pi/ΣP) of the air-conditioning performance of the air conditioner to the total of the air-conditioning performance of the plurality of air conditioners.

Next, the region correction unit 106 calculates a partition region area ai (step ST205).

The partition region area ai is an area of the partition region obtained by the Voronoi partition.

That is, the region correction unit 106 calculates partition region areas a1, a2, a3, and a4 of the partition regions r1, r2, r3, and r4 in Fig. 4, respectively.

Next, the region correction unit 106 initializes a weight coefficient between the air conditioners (step ST206). Details of the weight coefficient will be described later.

Next, the region correction unit 106 extracts an air conditioner whose absolute value of a difference between the performance proportional-distribution area Ai and the partition region area ai is maximum (step ST207).

In a case of Fig. 4, the region correction unit 106 extracts from among the air conditioners AC1, AC2, AC3, and AC4, the air conditioner whose absolute value of the difference between the performance proportional-distribution area Ai and the partition region area ai is maximum. Note that, if there exist a plurality of air conditioners whose differences are the same, the region correction unit 106 extracts the air conditioner by prioritizing the air conditioner with a smaller subscript value.

Note that, the air conditioner extracted in step ST207 is equivalent to an incoincident air conditioner. Also, the partition region which includes the incoincident air conditioner is equivalent to an incoincident partition region.

Next, the region correction unit 106 calculates a parallel translation amount of the Voronoi boundary line of a partition region which has as the seed point, the air conditioner extracted in step ST207 (step ST208). A calculation procedure of the parallel translation amount will be described later.

Next, the region correction unit 106 calculates for al1 of the air conditioners, areas (referred to as adjusted areas Nri) of partition regions after translating the Voronoi boundary lines in parallel (step ST209).

Next, the region correction unit 106 determines for each air conditioner, whether or not the adjusted area Nri satisfies a threshold condition (step ST210). Details of the threshold condition will be described later.

If the adjusted areas Nri of all of the air conditioners satisfy the threshold condition, the region correction unit 106 ends the process.

On the other hand, one of the adjusted areas Nri of the air conditioners does not satisfy the threshold condition, the region correction unit 106 treats the adjusted area Nri as a new partition region area ai, and performs a process of step ST207 and processes after step ST207. Until the absolute values of the differences between the adjusted areas Nri and the performance proportional-distribution areas Ai satisfy the threshold condition, the region correction unit 106 repeats the process of step ST207 and the processes after step ST207.

Next, the threshold condition of step ST210 will be described.

In order to perform accurate heat load calculation which reflects a difference in the air-conditioning performance between the air conditioners, it is ideal if the difference between the performance proportional-distribution area Ai and the adjusted area Nri becomes zero. However, actually, there is a case where the difference does not converge into zero. In the present embodiment, a threshold condition is provided in order to end the processes of the region correction unit 106 in a case where the difference does not converge into zero.

The region correction unit 106 can set, for example, a threshold condition that the absolute value of the difference between the performance proportional-distribution area Ai and the adjusted area Nri falls within an acceptable range. That is, when the absolute values of the differences between the performance proportional-distribution areas Ai and the adjusted areas Nri fall within the acceptable area for all the air conditioners, the region correction unit 106 determines that the adjusted areas Nri satisfy the threshold condition (YES in ST210).

Alternatively, the region correction unit 106 may set, for example, a threshold condition that a ratio (Nri/Ai) of the adjusted area Nri to the performance proportional-distribution area Ai falls within an acceptable range. That is, when the ratios (Nri/Ai) of the adjusted areas Nri to the performance proportional-distribution areas Ai fall within the acceptable range for all of the air conditioners, the region correction unit 106 determines that the adjusted areas Nri satisfy the threshold condition (YES in ST210).

Alternatively, the region correction unit 106 may also set a threshold condition that the number of repetitions of the processes of steps ST207 to ST210 exceeds an upper limit value. That is, when the number of repetitions of the processes of steps ST207 to ST210 exceeds the upper limit value, the region correction unit 106 determines that the adjusted areas Nri satisfy the threshold condition (YES in ST210).

Alternatively, the region correction unit 106 may also set a threshold condition that a translation amount of the Voronoi boundary line exceeds an upper limit value. That is, when the parallel translation amount of the Voronoi boundary line calculated for one of the air conditioners exceeds the upper limit value, the region correction unit 106 determines that the adjusted areas Nri satisfy the threshold condition (YES in ST210). For example, it is conceivable that the region correction unit 106 employs a half of a distance between the air conditioners as the upper limit value of the parallel translation amount.

Here, a procedure of calculating the parallel translation amount of the Voronoi boundary line in step ST208 will be described.

As a method of translating the Voronoi boundary line in parallel, an additively weighted power Voronoi partition means is known. This means is a means of depicting the Voronoi diagram in such a manner that a point m on a plane including seed points $m_k$ and $m_{k+1}$ satisfies an equation 2.
[formula 2]

$$\| m - m_k \|^2 - w = \| m - m_{k+1} \|^2 + w \quad \text{(equation 2)}$$

Here, w represents a weight coefficient between the seed points $m_k$ and $m_{k+1}$. The boundary line is a straight line parallel with a perpendicular bisector between the seed points $m_k$ and $m_{k+1}$. When coordinates of the seed points $m_k$ and $m_{k+1}$, and a point m are assumed to be (0, 0), (X, 0), and (m, 0), respectively, and the parallel translation amount of the boundary line between the seed points $m_k$ and $m_{k+1}$ is assumed to be $d_{k,k+1}$, the equation 2 becomes an equation 3.
[formula 3]

$$d_{k,\ k+1} = \mathrm{m} - \frac{X}{2} = \frac{w}{X} \quad \text{(equation 3)}$$

Therefore, the parallel translation amount of the boundary line can be decided, using the weight between the seed points and the distance between the seed points.

In a case of the weight coefficient w>0, the boundary line translates in parallel in a direction of getting away from the seed point $m_k$, and in a case of w<0, the boundary line translates in parallel in a direction of getting closer to the seed point $m_k$.

In the present embodiment, the weight coefficient of the air conditioner i is defined in an equation 4.
[formula 4]

$$w_{i,\ n} = w_{i,\ n-1} + \Delta \mathrm{w} \quad (\mathrm{n} = 1,\ 2, \ldots) \quad \text{(equation 4)}$$

n in the equation 4 is the number of times of a calculation process of obtaining the translation amount of the boundary line. A weight coefficient $w_{1,n-1}$ which is a first member on a right-hand side of the equation 4 is the weight coefficient used in the last process before the process returns from steps ST210 to ST207. The latest weight coefficient $w_{i,n}$ is a value obtained by adding weight $\Delta w$ being an increased amount to the weight coefficient $w_{i,n-1}$ used before the process returns to step ST207. A case where the difference between the performance proportional-distribution area Ai and the partition region area ai is equal to or larger than zero ($Ai-ai \geq 0$), results in $\Delta w \geq 0$. On the other hand, a case where the difference between the performance proportional-distribution area Ai and the partition region area ai is smaller than zero ($Ai-ai<0$), results in $\Delta w<0$. Magnitude of absolute value of $\Delta w$ is decided arbitrarily in advance.

Next, a procedure of calculating the parallel translation amount of the boundary line according to the present embodiment will be described with reference to Figs. 6 and 7. Figs. 6 and 7 are flowcharts illustrating details of the procedure (step ST208 in Fig. 5) of calculating the parallel translation amount of the boundary line according to the present embodiment.

First, the region correction unit 106 extracts all of the air conditioners k (k=1, 2,.. n) which have a partition region adjacent to the partition region of the air conditioner i whose absolute value of the difference between the performance proportional-distribution area Ai and the partition region area ai is maximum, the air conditioner i being extracted in step ST207 of Fig. 5 (step ST301).

Note that, note that, the air conditioner k extracted in step ST301 is referred to as an adjacent air conditioner k.

Next, the region correction unit 106 determines whether or not there is a performance difference between the air-conditioning performance Pk of the extracted adjacent air conditioner k and the air-conditioning performance Pi of the air conditioner i (step ST302).

If in step ST302, there is no performance difference between the air-conditioning performance Pk of the adjacent air conditioner k and the air-conditioning performance Pi of the air conditioner i, the boundary line with the partition region of the adjacent air conditioner k does not need to be translated, and the region correction unit 106 sets a parallel translation amount dik of the boundary line to zero (step ST303).

On the other hand, if in step ST302, there is the performance difference between the air-conditioning performance Pk of the adjacent air conditioner k and the air-conditioning performance Pi of the air conditioner i, the region correction unit 106 obtains a performance ratio $P_{ik}$, according to an equation 5 (step ST304).

$$P_{ik}=Pi/Pk \quad \text{(equation 5)}$$

Then, the region correction unit 106 reads a distance Xik between the adjacent air conditioner k and the air conditioner i from the BIM data (step ST305).

The region correction unit 106 performs steps ST304 and ST305 on all of the adjacent air conditioners k whose performance is different from the air conditioner i (step ST306).

If there exists only one adjacent air conditioner k which has the performance difference, the region correction unit 106 selects the adjacent air conditioner k. Further, if there exist a plurality of adjacent air conditioners k which have the performance differences, the region correction unit 106 designates an arbitrary adjacent air conditioner k among the plurality of adjacent air conditioners k. Then, the region correction unit 106 calculates the parallel translation amount $d_{ik}$ of the boundary line according to equation 6, treating the adjacent air conditioner k designated as a reference (ST307). Note that, the adjacent air conditioner k designated by the region correction unit 106 is referred to as a designated adjacent air conditioner k.

[formula 5]

$$d_{ik}=\frac{w_{i,\ n}}{X_{ik}}P_{ik} \qquad \text{(equation 6)}$$

The weight coefficient $w_{i,n}$ of the equation 6 is obtained according to the equation 4.

If the parallel translation amount $d_{ik}=0$ is set in step ST303, the region correction unit 106 does not perform step ST307.

Next, the region correction unit 106 determines whether or not the adjacent air conditioner k whose performance is different from the air conditioner i exists except for the designated adjacent air conditioner k (step ST308).

If the adjacent air conditioner k whose performance is different from the air conditioner i does not exist except for the designated adjacent air conditioner k, the calculation process of the parallel translation amount ends here since the only one boundary line is subject to the parallel translation process.

On the other hand, if the adjacent air conditioner k whose performance is different from the air conditioner i exists except for the designated adjacent air conditioner k, the region correction unit 106 selects as a selected adjacent air conditioner n, one adjacent air conditioners k out of the adjacent air conditioners k whose performance is different from the air conditioner i, and the process proceeds to processes of obtaining the parallel translation amount of the boundary line with the selected adjacent air conditioner n (a process of step ST309 and processes after step ST309).

The region correction unit 106 obtains a parallel translation amount $d_{in}$ of the boundary line with the selected adjacent air conditioner n, treating as a reference, the parallel translation amount $d_{ik}$ of the boundary line with the designated adjacent air conditioner k obtained in step ST307.

First, the region correction unit 106 corrects an air-conditioning performance ratio $P_{in}$ between the air conditioner i and the selected adjacent air conditioner n, which is obtained in step ST304, according to an equation 7, using the performance ratio $P_{ik}$ between the air conditioner i and the designated adjacent air conditioner k (step ST309).

[formula 6]

$$NP_{in}=\frac{P_{in}}{P_{ik}} \qquad \text{(equation 7)}$$

Further, the region correction unit 106 corrects a distance $X_{in}$, between the air conditioner i and the selected adjacent air conditioner n, which is obtained in step ST305, according to an equation 8, using the distance $X_{ik}$ between the air conditioner i and the designated adjacent air conditioner k (step ST310).

[formula 7]

$$NX_{in}=\frac{X_{in}}{X_{ik}} \qquad \text{(equation 8)}$$

$NP_{in}$ of the equation 7 is the corrected performance ratio between the air conditioner i and the selected adjacent air conditioner n. Further, $NX_{in}$ of the equation 8 is the corrected distance between the air conditioner i and the selected adjacent air conditioner n.

Next, the region correction unit 106 obtains the parallel translation amount $d_{in}$ of the boundary line between the air conditioner i and the selected adjacent air conditioner n according to an equation 9 (step ST311).

[formula 8]

$$d_{in}=\frac{d_{ik}}{NX_{in}}NP_{in} \qquad \text{(equation 9)}$$

After the region correction unit 106 performs the processes of steps ST309 to ST311 on one selected adjacent air conditioner n, the region correction unit 106 selects an unselected adjacent air conditioner k as a new selected adjacent air conditioner n. After the region correction unit 106 performs the processes of steps ST309 to ST311 on all of the selected adjacent air conditioners n, the region correction unit 106 calculates the parallel translation amount of the boundary line between the air conditioner i and each selected adjacent air conditioner n.

The processes in the present embodiment will be described, using placement of the air conditioners illustrated in Fig. 3 as an example.

In Fig. 3, the air-conditioning space 201 is a rectangular. Therefore, the line segment X12 connecting the air conditioners AC1 and AC2 is parallel with peripheries of the air-conditioning space 201 in a horizontal direction. Similarly, the line segment X34 connecting the air conditioners AC3 and AC4 is parallel with peripheries of the air-conditioning space 201 in a horizontal direction. The line segment X13 connecting the air conditioners AC1 and AC3 is parallel with peripheries of the air-conditioning space 201 in a vertical direction. Similarly, the line segment X24 connecting the air conditioners AC2 and AC4 is parallel with peripheries of the air-conditioning space 201 in a vertical direction.

Length of each straight line is X12=X34 and X13=X24. The air conditioners AC1, AC2, AC3, and AC4 are placed in a grid pattern in the air-conditioning space 201. Further, each air conditioner is placed in such a manner that a center point of the rectangular shaped by the line segments X12, X13, X34, and X24 connecting each air conditioner coincides with a center point of the air-conditioning space 201.

In the present embodiment, a ratio between the distances X12 and X13 between each air conditioner and a ratio between the performance P1, P2, P3, and P4 of each air conditioner are set as follows.

$$X12:X13=1:2 \qquad \text{(equation 10)}$$

$$P1:P2:P3:P4=1:0.8:0.6:0.6 \qquad \text{(equation 11)}$$

First, the space-data processing unit 102 acquires the shape data of the air-conditioning space 201 from the BIM data (step ST201). Further, the air-conditioner-data processing unit 103 acquires the total area R of the air-conditioning space 201, the positions of the air conditioners AC1, AC2, AC3, and AC4 in the air-conditioning space 201, the respective air-conditioning performance P1, P2, P3 and P4, a distance $X_{12}$ between the air conditioners AC1 and AC2, and a distance $X_{13}$ between the air conditioners AC1 and AC3 (step ST202).

Next, the Voronoi-partition processing unit 105 performs a Voronoi-partition process, treating the position of each air conditioner as the seed point (step ST203). Thereby, the boundary line b12 between the air conditioner AC1 and the air conditioner AC2, the boundary line b13 between the air conditioner AC1 and the air conditioner AC3, the boundary line b24 between the air conditioner AC2 and the air conditioner AC4, and the boundary line b34 between the air conditioner AC3 and the air conditioner AC4 are decided. Further, the respective partition regions r1, r2, r3, and r4 of the air conditioners AC1, AC2, AC3, and AC4 which are the seed points are acquired.

Next, the region correction unit 106 calculates the proportional-distribution areas A1, A2, A3, and A4 reflecting proportional distribution of the air-conditioning performance of each air conditioner, according to the equation 1, using the respective air-conditioning performance P1, P2, P3, and P4 of the air conditioners AC1, AC2, AC3, and AC4 (step ST204).

In the example of Fig. 3, when the air-conditioning performance P1 of the air conditioner AC1 is treated as a reference, the proportional-distribution areas A1, A2, A3, and A4 are as follows.

$$A1=5/(15P1)*R \quad \text{(equation 12)}$$

$$A2=4/(15P1)*R \quad \text{(equation 13)}$$

$$A3=A4=3/(15P1)*R \quad \text{(equation 14)}$$

Next, the region correction unit 106 calculates the partition region areas a1, a2, a3, and a4 which are respective areas of the partition regions r1, r2, r3, and r4 (step ST205).

In the example of Fig. 3, the partition region areas a1, a2, a3, and a4 are all equal to each other as indicated below.

$$a1=a2=a3=a4=R/4 \quad \text{(equation 15)}$$

Next, the region correction unit 106 initializes the weight coefficient $w_{i,n}$ between the air conditioners i, which is obtained in the equation 4 (step ST206). In the present embodiment, $w_{i,0}=0$ is premised.

Note that, magnitude of the increased amount $\Delta w$ of the weight coefficient indicated in the equation 4 is minimum resolution of the parallel translation amount of the boundary line. Therefore, the smaller the $\Delta w$ is, the more finely the parallel translation amount of the boundary line can be adjusted. However, if the $\Delta w$ is too small, the adjustment calculation amount for the translation amount of the boundary line becomes large between steps ST207 and ST210. It is desirable to set the magnitude of $\Delta w$ appropriately according to size of the air-conditioning space 201 and the number of air conditioners.

Hereinafter, a process of obtaining the translation amounts of the boundary lines of the partition regions starts.

First, the region correction unit 106 extracts the air conditioner whose difference between the performance proportional-distribution area Ai and the partition region area ai is maximum (step ST207). A relation in the equation 16 is obtained based on the equation 1 and the equation 15.

$$|A1-a1|>|A3-a3|=|A4-a4|>|A2-a2| \quad \text{(equation 16)}$$

As a result, the region correction unit 106 extracts the air conditioner AC1 as the air conditioner whose difference between the performance proportional-distribution area Ai and the partition region area ai is maximum.

Next, the region correction unit 106 calculates the translation amounts of the boundary lines of the partition regions adjacent to the partition region r1 of the air conditioner AC1 (step ST208).

First, the region correction unit 106 extracts the air conditioners AC2 and AC3 which are the seed points of all of the partition regions r2 and r3 adjacent to the partition region r1 of the air conditioner AC1 (step ST301).

Next, the region correction unit 106 determines whether or not there are differences in the air-conditioning performance between the air conditioner AC1 and the air conditioner AC2 and between the air conditioner AC1 and the air conditioner AC3 (step ST302).

In the present example, as seen in the equation 11, there is a difference between the air-conditioning performance P1 of the air conditioner AC1 and the air-conditioning performance P2 of the air conditioner AC2. Similarly, there is a difference between the air-conditioning performance P1 of the air conditioner AC1 and the air-conditioning performance P3 of the air conditioner AC3.

Since there is a difference between the air-conditioning performance P1 of the air conditioner AC 1 and the air-conditioning performance P2 of the air conditioner AC2, the region correction unit 106 calculates an air-conditioning performance ratio $P_{12}$ between the air conditioner AC1 and the air conditioner AC2 (step ST304).

Similarly, since there is a difference between the air-conditioning performance P1 of the air conditioner AC1 and the air-conditioning performance P3 of the air conditioner AC3, the region correction unit 106 calculates an air-conditioning performance ratio $P_{13}$ between the air conditioner AC1 and the air conditioner AC3 (step ST304).

The air-conditioning performance ratios $P_{12}$ and $P_{13}$ are calculated according to an equation 17 and an equation 18, respectively.

$$P_{12}=P1/P2 \quad \text{(equation 17)}$$

$$P_{13}=P1/P3 \quad \text{(equation 18)}$$

Further, the region correction unit 106 reads from the BIM data, the distances $X_{12}$ and $X_{13}$ from the adjacent air conditioners AC2 and AC3, respectively.

Here, the region correction unit 106 performs the process of step ST307, treating as references, the air-conditioning performance difference $P_{12}$ and the distance $X_{12}$ each of which is between the air conditioner AC1 and the air conditioner AC2. That is, here, the air conditioner AC2 is equivalent to the designated adjacent air conditioner k, and the air conditioner AC3 is equivalent to the selected adjacent air conditioner n.

The region correction unit 106 calculates a parallel translation amount $d_{12}$ of the boundary line b12 between the partition region r1 of the air conditioner AC1 and the partition region r2 of the air conditioner AC2 according to the equation 6 (step ST307).

In the present example, the parallel translation amount $d_{12}$ of the boundary line b12 is calculated according to an equation 19.

[formula 9]

$$d_{12}=\frac{w_{1,\,n}}{X_{12}}P_{12} \quad \text{(equation 19)}$$

A weight coefficient $w_{1,n}$ indicated in the equation 19 represents a weight coefficient at the n-th translation amount calculation process of the boundary line of the air conditioner AC1. Here, for the air conditioner AC1, the difference between the proportional-distribution area A1 and the partition region area a1 is equal to or larger than zero (A1-a1>0). For this reason, the boundary line b12 between the partition region r1 of the air conditioner AC1 and the partition region r2 of the air conditioner AC2 translates in parallel in a direction of getting away from the air conditioner AC 1, that is a direction in which the partition region r1 of the air conditioner AC1 expands.

Next, the region correction unit 106 determines whether or not there exists an air conditioner whose partition region is adjacent to the partition region r1 of the air conditioner AC 1 and whose performance is different from the air conditioner AC1, except for the air conditioner AC2 (step ST308).

In the example of Fig. 3, the air conditioner AC3 exists. Therefore, the region correction unit 106 corrects the air-conditioning performance ratio $P_{13}$ between the air conditioner AC1 and the air conditioner AC3 according to the equation 7, using the air-conditioning performance ratio $P_{12}$ between the air conditioner AC1 and the air conditioner AC2 (step ST309).

Further, the region correction unit 106 corrects the distance $X_{13}$ between the air conditioner AC1 and the air conditioner AC3 according to the equation 8, using the distance $X_{12}$ between the air conditioner AC1 and the air conditioner AC2 (step ST310).

A corrected air-conditioning performance ratio $NP_{13}$ between the air conditioner AC1 and the air conditioner AC3 is obtained according to the equation 20. Also, a corrected distance $NX_{13}$ between the air conditioner AC1 and the air conditioner AC3 is obtained according to the equation 21.

[formula 10]

$$NP_{13} = \frac{P_{13}}{P_{12}} \quad \text{(equation 20)}$$

$$NX_{13} = \frac{X_{13}}{X_{12}} \quad \text{(equation 21)}$$

Next, the region correction unit 106 obtains a parallel translation amount $d_{13}$ of the boundary line b 13 between the air conditioner AC1 and the air conditioner AC3 according to the equation 9 (step ST311).

In the present example, the parallel translation amount $d_{13}$ of the boundary line b13 between the air conditioner AC1 and the air conditioner AC3 is obtained according to an equation 22.

[formula 11]

$$d_{13} = \frac{d_{12}}{NX_{13}} NP_{13} \quad \text{(equation 22)}$$

Next, the region correction unit 106 translates the boundary line b12 in parallel by the translation amount $d_{12}$ in a direction of the line segment X12 and a direction in which the partition region r1 expands. Similarly, the region correction unit 106 translates the boundary line b13 in parallel by the translation amount $d_{13}$ in a direction of the line segment X13 and a direction in which the partition region r1 expands. Then, the region correction unit 106 calculates adjusted areas Nr1, Nr2, Nr3, and Nr4 which are the partition region areas of all of the respective air conditioners AC1, AC2, AC3, and AC4 in the air-conditioning space 201 after translating the boundary line b12 and the boundary line 13 in parallel (step ST209).

Then, the region correction unit 106 determines whether or not the adjusted areas Nr1, Nr2, Nr3, and Nr4 satisfy the threshold condition (step ST210).

For example, the threshold condition can be defined as indicated in an equation 23. If the threshold condition of the equation 23 is used, the region correction unit 106 ends the process when all of the adjusted areas Nri fall in a range of plus or minus 20% of the corresponding performance proportional-distribution areas Ai.

$$0.8 < Nri/Ai < 1.2 \quad \text{(equation 23)}$$

Nri: the adjusted area of the air conditioner i

Ai: the performance proportional-distribution area of the air conditioner i

Note that, since there is a possibility that the process does not end when only the threshold condition indicated in the equation 23 is employed, a threshold condition may be used that the process ends when a series of processes of steps ST207 to ST210 are performed more than the predetermined number of times. Alternatively, when the upper limit value on the translation amount of the boundary line is provided as the threshold condition, the upper limit value on the translation amounts of the boundary line b13 and the boundary line b24 may be a half distance of X13. Similarly, the upper limit value on the translation amounts of the boundary line b12 and the boundary line b34 may be a half distance of X12.

When the threshold condition is not satisfied in step ST210, the process returns to step ST207. Then, the region correction unit 106 treats the adjusted area Nri as the partition region area ai, extracts the air conditioner whose difference between the performance proportional-distribution area Ai and the partition region area ai is maximum, and repeats the processes of steps ST207 to ST210.

Figs. 8, 9, and 10 illustrate a transition in the translation process of the boundary lines and states after the translation processes.

Fig. 8 illustrates a state where the absolute value of the difference between the performance proportional-distribution area A4 and the partition region area a4 (adjusted area) for the air conditioner AC4 has become maximum as a result of repeating the parallel translation of the boundary lines b12 and b13. In Fig. 8, dashed lines in the air-conditioning space 201 indicate the original unadjusted boundary lines. In Fig. 8, solid lines indicate the adjusted (after the translation process) boundary lines, $d_{12}$ is the parallel translation amount of the boundary line b12. Nb12 is the adjusted boundary line b12. Similarly, $d_{13}$ is the parallel translation amount of the boundary line b13. Nb13 is the adjusted boundary line b13. The adjusted boundary lines Nb12 and Nb13 are extended to a point where Nb12 and Nb13 cross each other. Therefore, the partition region Nr1 of the air conditioner AC 1 after the translation of the boundary lines is a region surrounded by the adjusted boundary lines Nb 12 and Nb 13, and the periphery of the air-conditioning space 201. In the state illustrated in Fig. 8, it is assumed that all of the partition regions do not satisfy the threshold condition indicated in the equation 23.

Next, the region correction unit 106 performs the process of step ST208 and the processes after step ST208 in order to adjust the partition region Nr4 of the air conditioner AC4 whose difference between the proportional-distribution area Ai and the partition region area ai (adjusted area) has newly become maximum.

Here, the region correction unit 106 obtains the translation amounts of the boundary lines between the partition regions adjacent to the partition region Nr4 and the partition region Nr4 (step ST208).

In Fig. 8, the boundary lines between the partition regions adjacent to the partition region Nr4 and the partition region Nr4 are a boundary line Nb24 and a boundary line Nb34. The region correction unit 106 extracts the air conditioner AC2 included in the partition region Nr2 adjacent to the partition region Nr4 and the air conditioner AC4 included in the partition region Nr3 adjacent to the partition region Nr4 (step ST301).

Note that, as seen in the equation 14, there is no difference in the air-conditioning performance between the air conditioner AC3 and the air conditioner AC4. Thus, the region correction unit 106 does not translate the boundary line Nb34 (steps ST302 and ST303).

On the other hand, as seen in the equations 13 and 14, there is a difference in the air-conditioning performance between the air conditioner AC2 and the air conditioner AC4. Therefore, the region correction unit 106 performs the processes of steps ST304 to ST311 to obtain the parallel translation amount of the boundary line Nb24 (step ST307).

Fig. 9 illustrates the boundary lines of the partition region of each air conditioner in the air-conditioning space 201 after the boundary line b24 is translated. $d_{24}$ in Fig. 9 is the parallel translation amount of the boundary line $b_{24}$. The adjusted boundary line Nb24 has been translated in a direction in which the partition region Nr4 of the air conditioner AC4 shrinks. The partition region Nr4 of the air conditioner AC4 has a shape that the upper left part is dented. Therefore, the partition region Nr4 in Fig. 9 is not suitable as a region indicating the air-conditioner zone. That is because an actual air-conditioning range which the air conditioner covers is a simple shape and not a complicated shape such as a polygon which has a dented part. Then, the region correction unit 106 corrects the partition region Nr4. The region correction unit 106 corrects the partition region so as to eliminate dented part in the partition region of each air conditioner. Specifically, the region correction unit 106 provides as a new boundary line, a straight line connecting a point where the boundary line Nb12 and the boundary line Nb24 cross each other and a point where the boundary line Nb13 and the boundary line Nb12 cross each other.

Fig. 10 illustrates each corrected partition region.

A boundary line Nb14 in Fig. 10 is a new boundary line between the partition region Nr1 of the air conditioner AC1 and the partition region Nr4 of the air conditioner AC4. Such correction process may be performed by the display-data processing unit 107. Alternatively, the region correction unit 106 may perform the correction process after the process of step ST210 ends (threshold condition is satisfied).

Each adjusted partition region is displayed on the display device 16 via the display-data processing unit 107. An operator of the information processing apparatus 10 may adjust the translation amount of the boundary line by changing the increased amount $\Delta w$ of the weight coefficient or the threshold condition via a device interface or a communication interface, using outside input equipment, not illustrated, while viewing each partition region displayed on the display device 16.

*** Description of Effect of Embodiment ***

As described above, in the present embodiment, the areas of the partition regions are adjusted according to the air-conditioning performance. Therefore, according to the present embodiment, it is possible to realize the accurate heat load calculation reflecting the difference in the air-conditioning performance between the air conditioners.

Also, in the present embodiment, the boundary lines are simply translated in parallel. Therefore, according to the present embodiment, complicated calculation required when the air-conditioner zones are set is unnecessary. When a plurality of air conditioners are placed in the air-conditioning space, in many cases, the air conditioners are placed in a grid pattern as illustrated in Fig. 3. If one of the air conditioners illustrated in Fig. 3 is replaced with a new air conditioner which has different air-conditioning performance, it is necessary to reconsider the air-conditioner zones. According to the method indicated in the present embodiment, it is possible to easily reconsider the air-conditioner zones when the air conditioner is replaced with the new air conditioner.

Further, in the present embodiment, the air-conditioner zone of each air conditioner is displayed on the display device. Therefore, in the present embodiment, the operator can adjust the value of the increased amount Δw of the weight coefficient and the threshold condition while viewing the display. As a result, according to the present embodiment, the operator can adjust the air-conditioner zone finely.

Second Embodiment.

In the first embodiment above, an example has been described in which the air-conditioning space 201 is not influenced by a heat load from an outer wall or a window. However, the actual air-conditioning space 201 is influenced by the heat load from the outer wall or the window. Therefore, it is desirable to place an air conditioner having high air-conditioner performance in a perimeter region which is a region influenced by the load.

When the air-conditioner zone of the air conditioner in the perimeter region is set considering the air-conditioning performance, the air-conditioner zone of the air conditioner in the perimeter region may become larger than necessary. Therefore, in the present embodiment, the region correction unit 106 corrects the air-conditioning performance of the air conditioner in the perimeter region, using the heat load of the perimeter region.

In the present embodiment, mainly matters different from the first embodiment will be described.

Note that, matters not described below are the same as those in the first embodiment. For example, a hardware configuration example of the information processing apparatus 10 is as illustrated in Fig. 1. Also, a functional configuration example of the information processing apparatus 10 is as illustrated in Fig. 2.

Fig. 11 illustrates an air-conditioning space 401 according to the present embodiment.

The air-conditioning space 401 has an outer wall 402, a window 403, and a window 404.

Fig. 12 illustrates a state after the Voronoi partition is performed on the air-conditioning space 401, treating the air conditioners AC1, AC2, AC3, and AC4 as the seed points.

In Figs 11 and 12, the same reference numerals as the reference numerals included in Figs. 3 and 4 indicate the same elements.

In an example of Fig. 12, the perimeter region is included in the partition region r1 of the air conditioner AC1 where the window 403 is placed, the partition region r1 being adjoined by the outer wall 402. Similarly, the perimeter region is included in the partition region r2 of the air conditioner AC2 where the outer wall 402 is adjoined and the window 404 is placed.

Fig. 13 is a flowchart illustrating an operation example of the information processing apparatus 10 according to the present embodiment.

In Fig. 13, processes of steps ST201 to ST203 are the same as those indicated in the first embodiment.

In step ST400, the region correction unit 106 corrects the air-conditioning performance of the air conditioner whose partition region includes the perimeter region. Note that, the air conditioner whose partition region includes the perimeter region is referred to as a perimeter air conditioner.

Fig. 14 is a flowchart illustrating details of step ST400.

First, the region correction unit 106 determines for all of the partition regions, whether or not the perimeter region is included in the partition region (step ST401).

If there is the partition region including the perimeter region, the region correction unit 106 acquires the air-conditioning performance of the perimeter air conditioner located in the partition region. In the present embodiment, the air conditioners AC1 and AC2 correspond to the perimeter air conditioners. Therefore, the region correction unit 106 acquires the air-conditioning performance P1 and P2 of the respective air conditioners AC1 and AC2.

Next, the region correction unit 106 calculates the heat loads of the perimeter region (step ST402).

Specifically, the region correction unit 106 calculates a window heat load Q1i and a wall heat load Q2i as the heat loads of the perimeter region in a partition region i according to an equation 24 and an equation 25.

$$Q1i = \text{window area} * \text{window heat transmittance} * \text{coefficient a} \quad \text{(equation 24)}$$

$$Q2i = \text{wall area} * \text{wall heat transmittance} * \text{coefficient b} \quad \text{(equation 25)}$$

Coefficients a and b: maximum differences between indoor temperature and outdoor temperature, and the like

Note that, the region correction unit 106 acquires the window area, the wall area, the window heat transmittance, and the wall heat transmittance from the BIM data. The coefficients a and b are set by the operator as necessary considering conditions of the indoor temperature and the outdoor temperature, and the like.

In the present embodiment, the region correction unit 106 calculates a window heat load Q11 and a wall heat load Q21 for the partition region r1 including the perimeter region. Further, the region correction unit 1 06 calculates a window heat load Q12 and a wall heat load Q22 for the partition region r2 including the perimeter region.

Next, the region correction unit 106 corrects the air-conditioning performance Pi of the perimeter air conditioner i according to the equation 26, using the heat loads calculated in step ST402 (ST403).

$$Pi' = Pi - Q1i - Q2i \quad \text{(equation 26)}$$

Pi' in the equation 26 is the corrected air-conditioning performance.

The region correction unit 106 performs the processes of steps ST401 to ST403 on the partition regions of all of the air conditioners in the air-conditioning space 401 (ST404).

The air-conditioning performance P1 and P2 of the respective air conditioners AC1 and AC2 are corrected by the processes illustrated in Fig. 14.

In step ST204, the performance proportional-distribution areas for the air conditioners AC1 and AC2 are calculated using corrected air-conditioning performance P1' and P2', respectively.

A process of step ST205 and processes after step ST205 are the same as those indicated in the first embodiment.

As described above, in the present embodiment, the air-conditioning performance of the air conditioner is corrected considering influence of the heat load of the perimeter region. Therefore, according to the present embodiment, it is possible to set the air-conditioner zone suitable for a heat load situation of the air-conditioning space.

Although the first and second embodiments have been described above, these two embodiments may be combined and implemented.

Alternatively, one of these two embodiments may be partially implemented.

Alternatively, these two embodiments may be partially combined and implemented.

Further, the configurations and the procedures described in these two embodiments may be modified as necessary.

*** Supplementary Description of Hardware Configuration ***

Finally, supplementary descriptions of the hardware configuration of the information processing apparatus 10 will be given.

The processor 11 illustrated in Fig. 1 is an IC (Integrated Circuit) that performs processing.

The processor 11 is a CPU (Central Processing Unit), a DSP (Digital Signal Processor), or the like.

The main storage device 12 illustrated in Fig. 3 is a RAM (Random Access Memory).

The auxiliary storage device 13 illustrated in Fig. 3 is a ROM (Read Only Memory), a flash memory, an HDD (Dard Disk Drive), or the like.

The communication interface 15 illustrated in Fig. 3 is an electronic circuit that executes a communication process of data.

The communication interface 15 is, for example, a communication chip or an NIC (Network Interface Card).

Further, the auxiliary storage device 13 also stores an OS (Operating System). Then, at least a part of the OS is executed by the processor 11.

While executing at least the part of the OS, the processor 11 executes the programs which realize the functions of the BIM-data processing unit 101, the region generation unit 104, and the display-data processing unit 107.

By the processor 11 executing the OS, task management, memory management, file management, communication control, and the like are performed.

Further, at least one of information, data, a signal value, and a variable value that indicate results of processes of the BIM-data processing unit 101, the region generation unit 104, and the display-data processing unit 107 is stored in at least one of the main storage device 12, the auxiliary storage device 13, and a register and a cash memory in the processor 11.

Further, the programs which realize the functions of the BIM-data processing unit 101, the region generation unit 104, and the display-data processing unit 107 may be stored in a portable recording medium such as a magnetic disk, a flexible disk, an optical disc, a compact disc, a Blu-ray (registered trademark) disc, or a DVD. Then, the portable recording medium storing the programs which realize the functions of the BIM-data processing unit 101, the region generation unit 104, and the display-data processing unit 107 may be distributed.

Further, "unit" of the BIM-data processing unit 101, the region generation unit 104, and the display-data processing unit 107 may be read as "circuit", "step", "procedure", or "process".

Further, the information processing apparatus 10 may be realized by a processing circuit. The processing circuit is, for example, a logic IC (Integrated Circuit), a GA (Gate Array), an ASIC (Application Specific Integrated Circuit), or an FPGA (Field-Programmable Gate Array).

In this case, each of the BIM-data processing unit 101, the region generation unit 104, and the display-data processing unit 107 is realized as a part of the processing circuit.

Note that, in the present specification, a superordinate concept of the processor and the processing circuit is referred to as "processing circuitry".

That is, each of the processor and the processing circuit is a specific example of the "processing circuitry".

**Reference Signs List**

10: information processing apparatus, 11: processor, 12: main storage device, 13: auxiliary storage device, 14: device interface, 15: communication interface, 16: display device, 17: outside storage device, 101: BIM-data processing unit, 102: space-data processing unit, 103: air-conditioner-data, processing unit, 104: region generation unit, 105: Voronoi-partition processing unit, 106: region correction unit, 107: display-data processing unit, 201: air-conditioning space, 401: air-conditioning space, 402: outer wall, 403: window, 404: window.

**Claims**

1. An information processing apparatus comprising:

    a partition unit to perform Voronoi partition on a plane region of a space where a plurality of air conditioners are placed, treating as a seed point, a position where each of the plurality of air conditioners is placed, and generate a plurality of partition regions each of which includes any of the plurality of air conditioners; and
    an adjustment unit to adjust an area of at least one of the plurality of partition regions based on air-conditioning performance of each of the plurality of air conditioners.

2. The information processing apparatus according to claim 1, wherein
the adjustment unit adjusts the area of at least one of the plurality of partition regions by translating a Voronoi boundary line in parallel.

3. The information processing apparatus according to claim 1, wherein
the adjustment unit adjusts the area of at least one of the plurality of partition regions so that a ratio of an area of each adjusted partition region to a total area of the plane region coincides with a ratio of the air-conditioning performance of each air conditioner to a total of the air-conditioning performance of the plurality of air conditioners.

4. The information processing apparatus according to claim 1, wherein

    the adjustment unit
    multiplies a total area of the plane region by a ratio of the air-conditioning performance of the air conditioner to a total of the air-conditioning performance of the plurality of air conditioners so as to calculate a performance proportional-distribution area for each air conditioner,
    calculates an area of the partition region for each air conditioner,
    compares the performance proportional-distribution area with the area of the partition region, and
    as a result of comparison, when there exists an incoincident air conditioner which is an air conditioner whose performance proportional-distribution area does not coincide with the area of the partition region, adjusts the area of the partition region including the incoincident air conditioner.

5. The information processing apparatus according to claim 4, wherein

    the adjustment unit
    designates as a designated adjacent air conditioner, among a plurality of adjacent air conditioners which are a plurality of air conditioners included in a plurality of adjacent partition regions which are a plurality of partition regions adjacent to an incoincident partition region which is the partition region including the incoincident air conditioner, an adjacent air conditioner whose air-conditioning performance is different from the incoincident air conditioner,
decides based on a ratio of the air-conditioning performance between the incoincident air conditioner and the designated adjacent air conditioner, a translation amount of a Voronai boundary line between the incoincident partition region and the adjacent partition region including the designated adjacent air conditioner, and
adjusts an area of the incoincident partition region, translating the Voronai boundary line according to the decided translation amount.

**6.** The information processing apparatus according to claim 5, wherein

the adjustment unit
when there exists the adjacent air conditioner whose air-conditioning performance is different from the incoincident air conditioner except for the designated adjacent air conditioner, selects as a selected adjacent air conditioner, the adjacent air conditioner whose air-conditioning performance is different from the incoincident air conditioner except for the designated adjacent air conditioner,
decides based on the ratio of the air-conditioning performance between the incoincident air conditioner and the designated adjacent air conditioner and a ratio of the air-conditioning performance between the incoincident air conditioner and the selected adjacent air conditioner, a translation amount of a Voronai boundary line between the incoincident partition region and an adjacent partition region including the selected adjacent air conditioner, and
adjusts the area of the incoincident partition region, translating the Voronai boundary line according to the decided translation amount.

**7.** The information processing apparatus according to claim 5, wherein
the adjustment unit does not translate a Voronai boundary line between the incoincident partition region and an adjacent partition region including an adjacent air conditioner whose air-conditioning performance is not different from the incoincident air conditioner.

**8.** The information processing apparatus according to claim 1, wherein

the adjustment unit
when there exists a partition region including a perimeter region among the plurality of partition regions,
corrects air-conditioning performance of a perimeter air conditioner which is an air conditioner included in the partition region including the perimeter region, using a heat load from the perimeter region, and adjusts the area of at least one of the plurality of partition regions, applying the corrected air-conditioning performance to the perimeter air conditioner.

**9.** An information processing method comprising:

performing, by a computer, Voronoi partition on a plane region of a space where a plurality of air conditioners are placed, while treating as a seed point, a position where each of the plurality of air conditioners is placed, and generating a plurality of partition regions each of which includes any of the plurality of air conditioners; and
adjusting, by the computer, an area of at least one of the plurality of partition regions based on air-conditioning performance of each of the plurality of air conditioners.

**10.** An information processing program which causes a computer to execute:

a partition process of performing Voronoi partition on a plane region of a space where a plurality of air conditioners are placed, while treating as a seed point, a position where each of the plurality of air conditioners is placed, and generating a plurality of partition regions each of which includes any of the plurality of air conditioners; and
an adjustment process of adjusting an area of at least one of the plurality of partition regions based on air-conditioning performance of each of the plurality of air conditioners.

Fig. 1

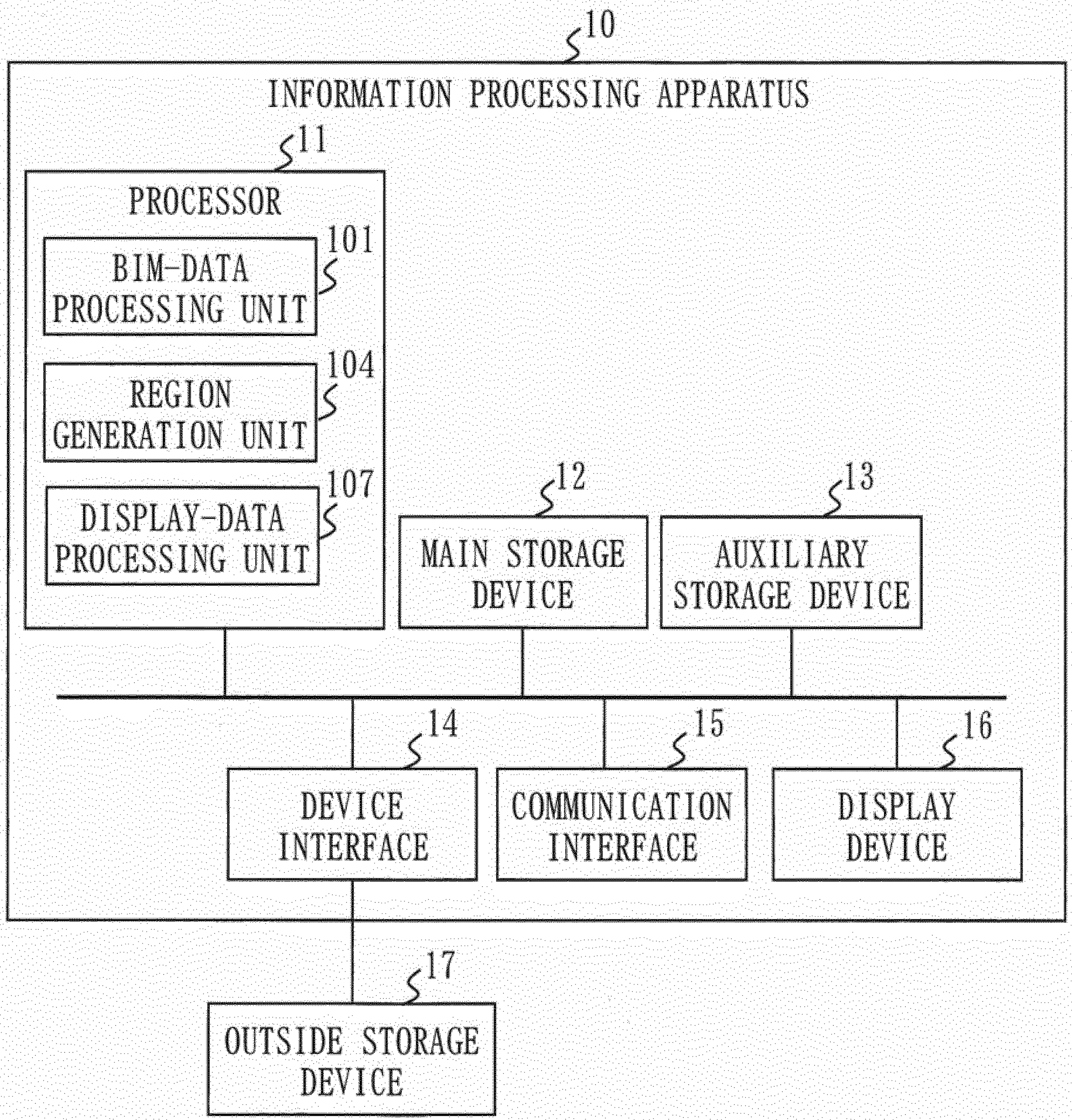
10
INFORMATION PROCESSING APPARATUS
11
PROCESSOR
101
BIM-DATA PROCESSING UNIT
104
REGION GENERATION UNIT
107
DISPLAY-DATA PROCESSING UNIT
12
MAIN STORAGE DEVICE
13
AUXILIARY STORAGE DEVICE
14
DEVICE INTERFACE
15
COMMUNICATION INTERFACE
16
DISPLAY DEVICE
17
OUTSIDE STORAGE DEVICE

Fig. 2

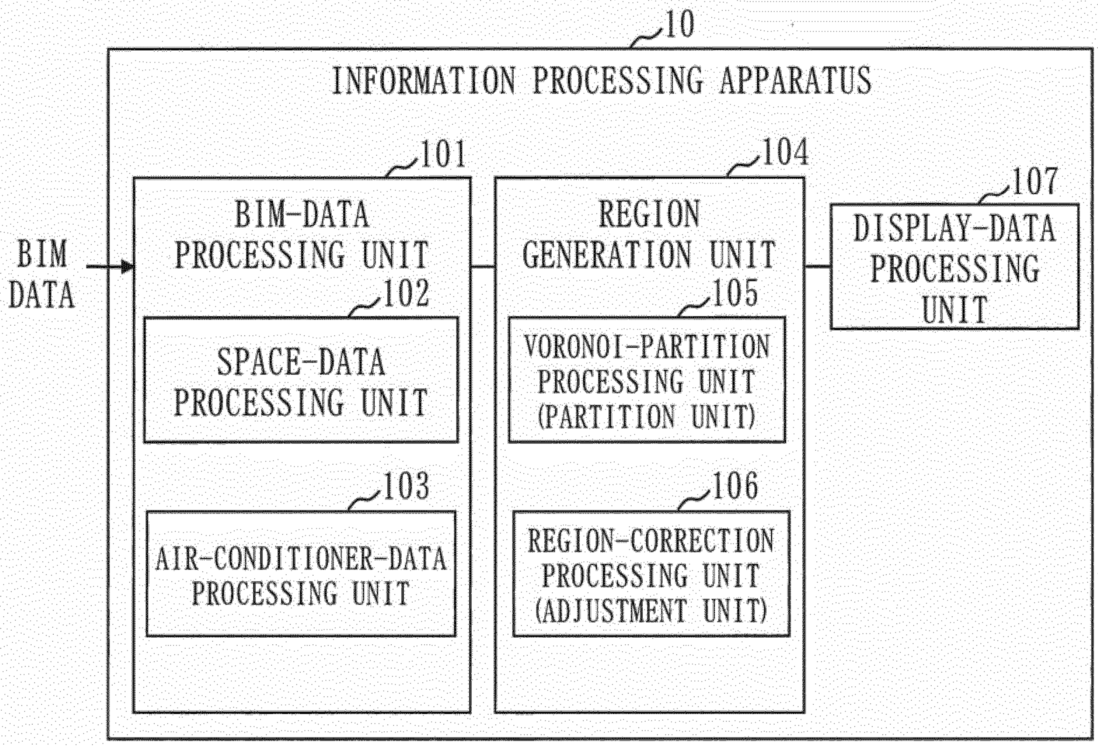
10
INFORMATION PROCESSING APPARATUS
101
BIM-DATA PROCESSING UNIT
BIM DATA
102
SPACE-DATA PROCESSING UNIT
103
AIR-CONDITIONER-DATA PROCESSING UNIT
104
REGION GENERATION UNIT
105
VORONOI-PARTITION PROCESSING UNIT (PARTITION UNIT)
106
REGION-CORRECTION PROCESSING UNIT (ADJUSTMENT UNIT)
107
DISPLAY-DATA PROCESSING UNIT

Fig. 3

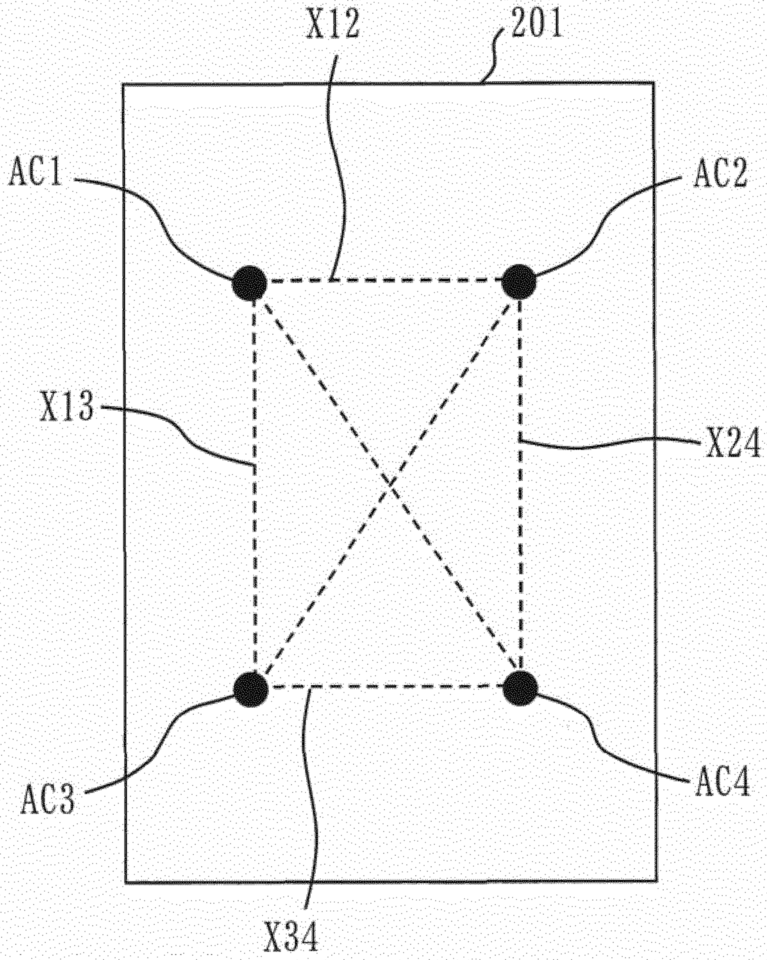

Fig. 4

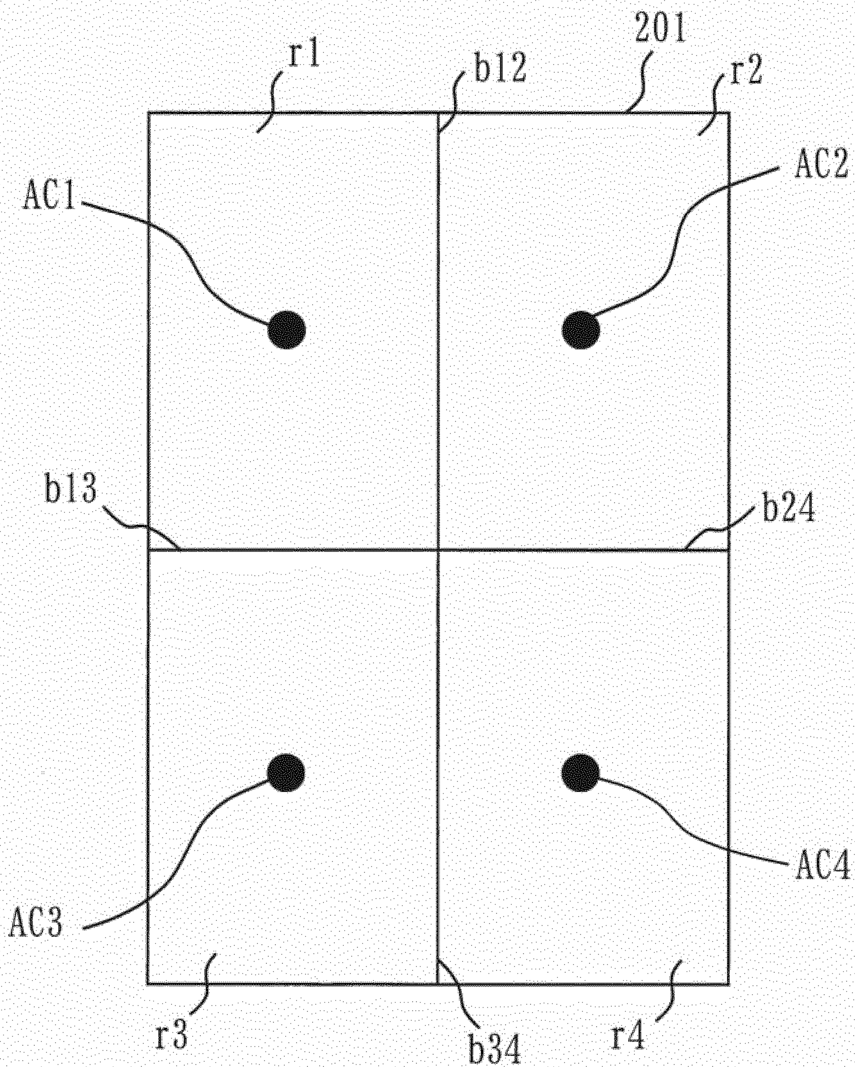

Fig. 5

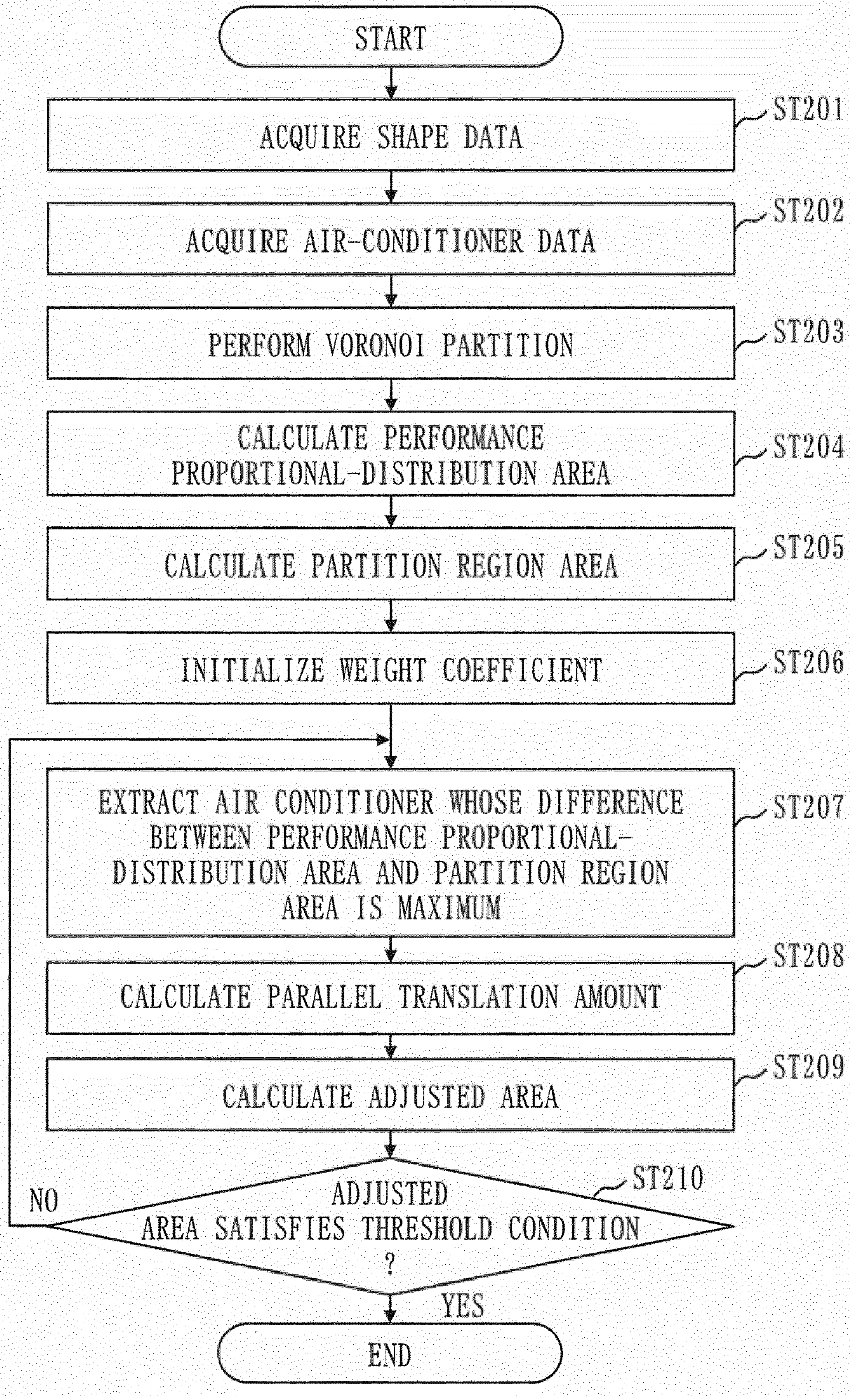
START
ACQUIRE SHAPE DATA
ST201
ACQUIRE AIR-CONDITIONER DATA
ST202
PERFORM VORONOI PARTITION
ST203
CALCULATE PERFORMANCE PROPORTIONAL-DISTRIBUTION AREA
ST204
CALCULATE PARTITION REGION AREA
ST205
INITIALIZE WEIGHT COEFFICIENT
ST206
EXTRACT AIR CONDITIONER WHOSE DIFFERENCE BETWEEN PERFORMANCE PROPORTIONAL-DISTRIBUTION AREA AND PARTITION REGION AREA IS MAXIMUM
ST207
CALCULATE PARALLEL TRANSLATION AMOUNT
ST208
CALCULATE ADJUSTED AREA
ST209
ADJUSTED AREA SATISFIES THRESHOLD CONDITION ?
ST210
NO
YES
END

Fig. 6

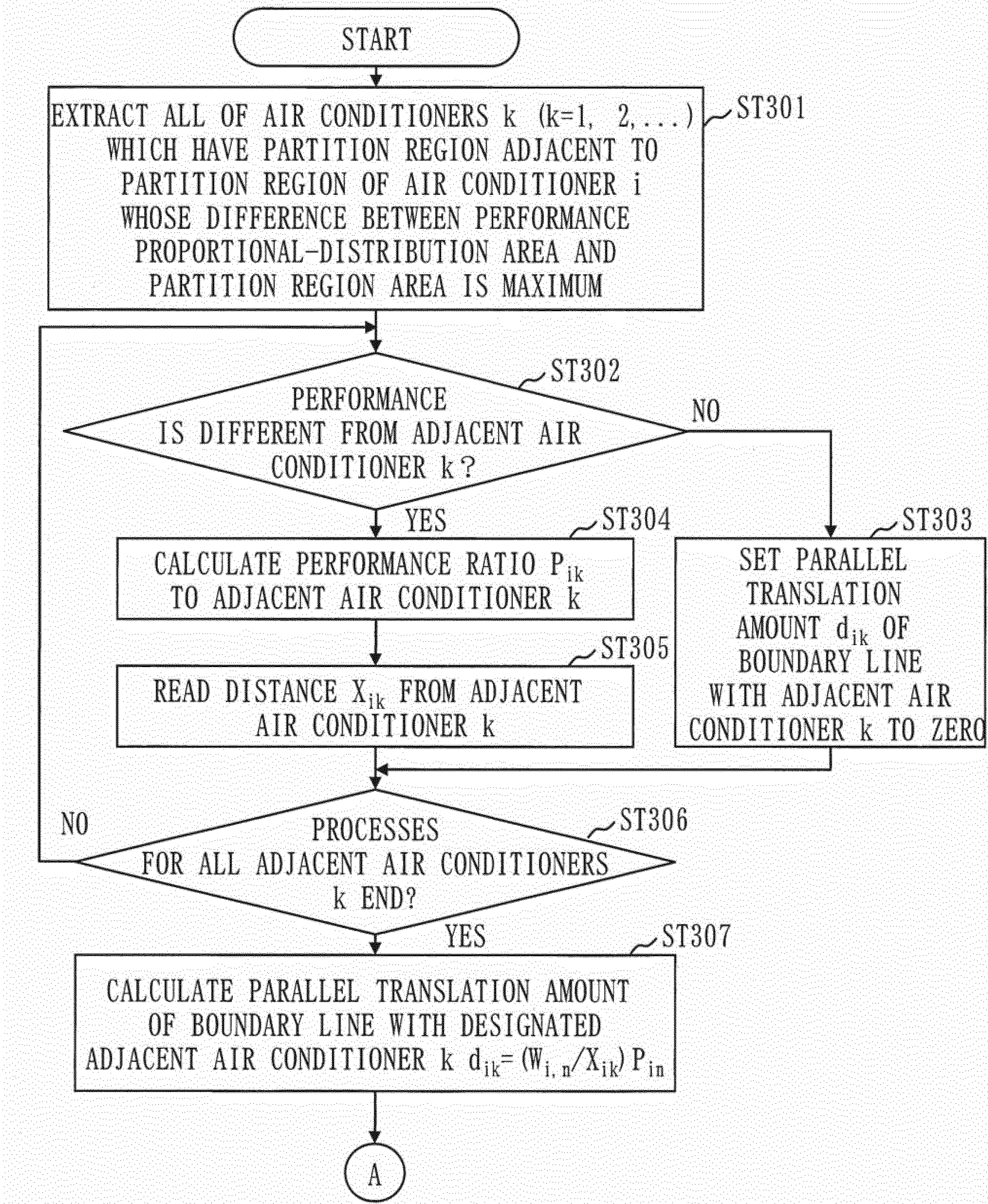
START
EXTRACT ALL OF AIR CONDITIONERS k (k=1, 2, ...) WHICH HAVE PARTITION REGION ADJACENT TO PARTITION REGION OF AIR CONDITIONER i WHOSE DIFFERENCE BETWEEN PERFORMANCE PROPORTIONAL-DISTRIBUTION AREA AND PARTITION REGION AREA IS MAXIMUM
ST301
PERFORMANCE IS DIFFERENT FROM ADJACENT AIR CONDITIONER k?
ST302
NO
YES
CALCULATE PERFORMANCE RATIO $P_{ik}$ TO ADJACENT AIR CONDITIONER k
ST304
SET PARALLEL TRANSLATION AMOUNT $d_{ik}$ OF BOUNDARY LINE WITH ADJACENT AIR CONDITIONER k TO ZERO
ST303
READ DISTANCE $X_{ik}$ FROM ADJACENT AIR CONDITIONER k
ST305
PROCESSES FOR ALL ADJACENT AIR CONDITIONERS k END?
ST306
NO
YES
CALCULATE PARALLEL TRANSLATION AMOUNT OF BOUNDARY LINE WITH DESIGNATED ADJACENT AIR CONDITIONER k $d_{ik}=(W_{i,n}/X_{ik})P_{in}$
ST307
A

Fig. 7

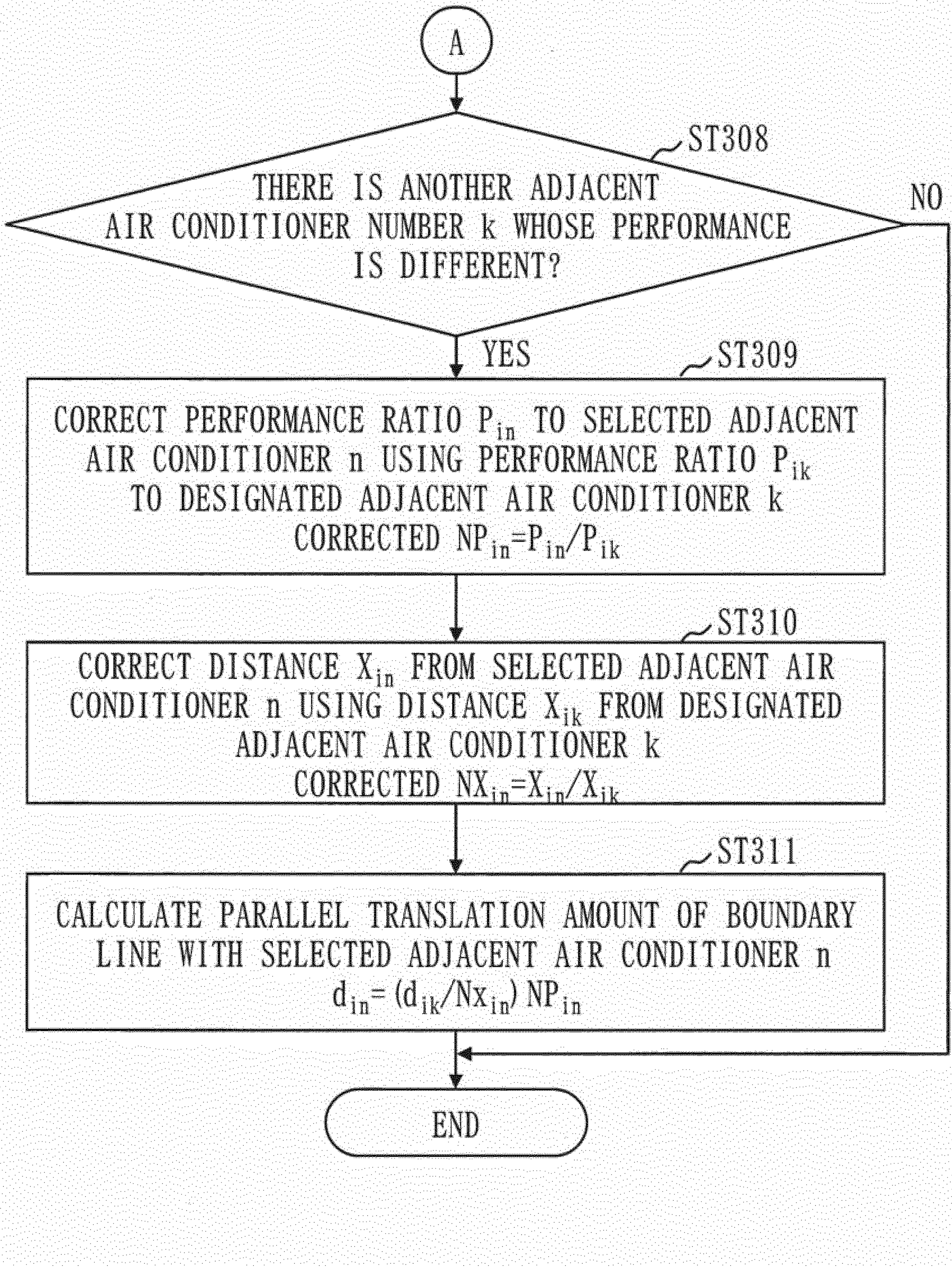
A
ST308
THERE IS ANOTHER ADJACENT AIR CONDITIONER NUMBER k WHOSE PERFORMANCE IS DIFFERENT?
NO
YES
ST309
CORRECT PERFORMANCE RATIO $P_{in}$ TO SELECTED ADJACENT AIR CONDITIONER n USING PERFORMANCE RATIO $P_{ik}$ TO DESIGNATED ADJACENT AIR CONDITIONER k
CORRECTED $NP_{in}=P_{in}/P_{ik}$
ST310
CORRECT DISTANCE $X_{in}$ FROM SELECTED ADJACENT AIR CONDITIONER n USING DISTANCE $X_{ik}$ FROM DESIGNATED ADJACENT AIR CONDITIONER k
CORRECTED $NX_{in}=X_{in}/X_{ik}$
ST311
CALCULATE PARALLEL TRANSLATION AMOUNT OF BOUNDARY LINE WITH SELECTED ADJACENT AIR CONDITIONER n
$d_{in}=(d_{ik}/Nx_{in})\ NP_{in}$
END

Fig. 8

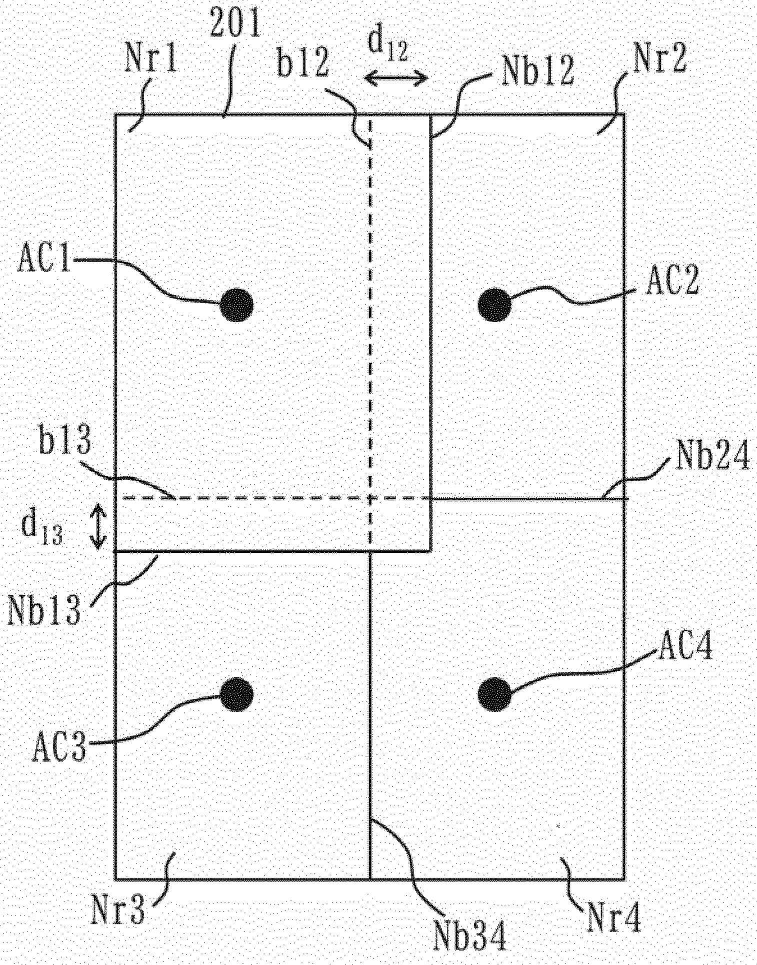
201
Nr1
b12
$d_{12}$
Nb12
Nr2
AC1
AC2
b13
Nb24
$d_{13}$
Nb13
AC4
AC3
Nr3
Nb34
Nr4

Fig. 9

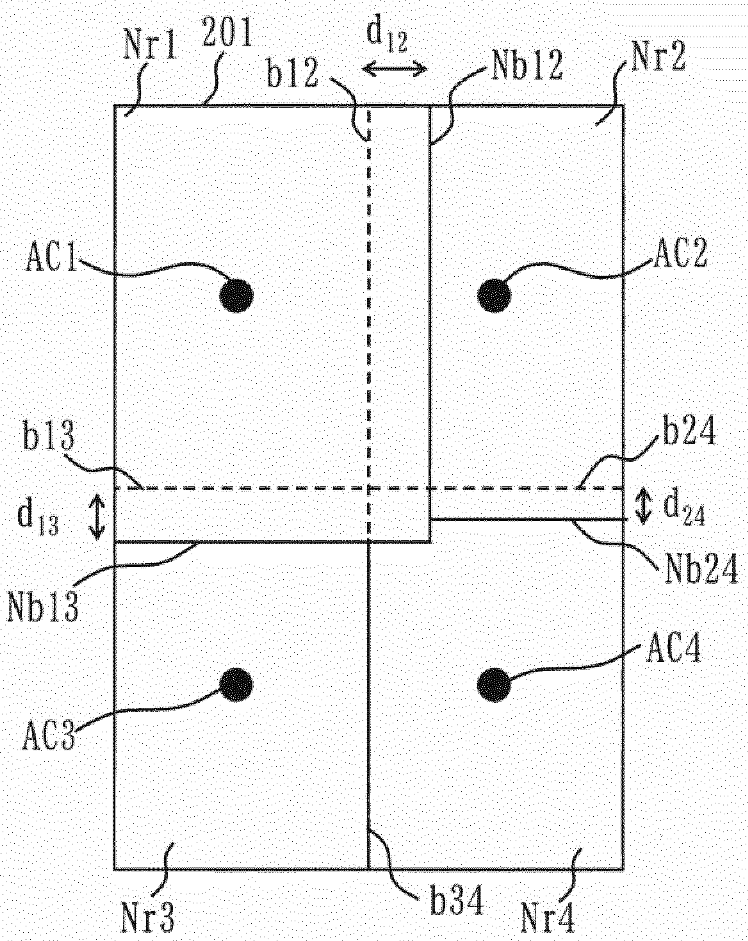
Nr1
201
b12
d12
Nb12
Nr2
AC1
AC2
b13
b24
d13
d24
Nb13
Nb24
AC4
AC3
Nr3
b34
Nr4

Fig. 10

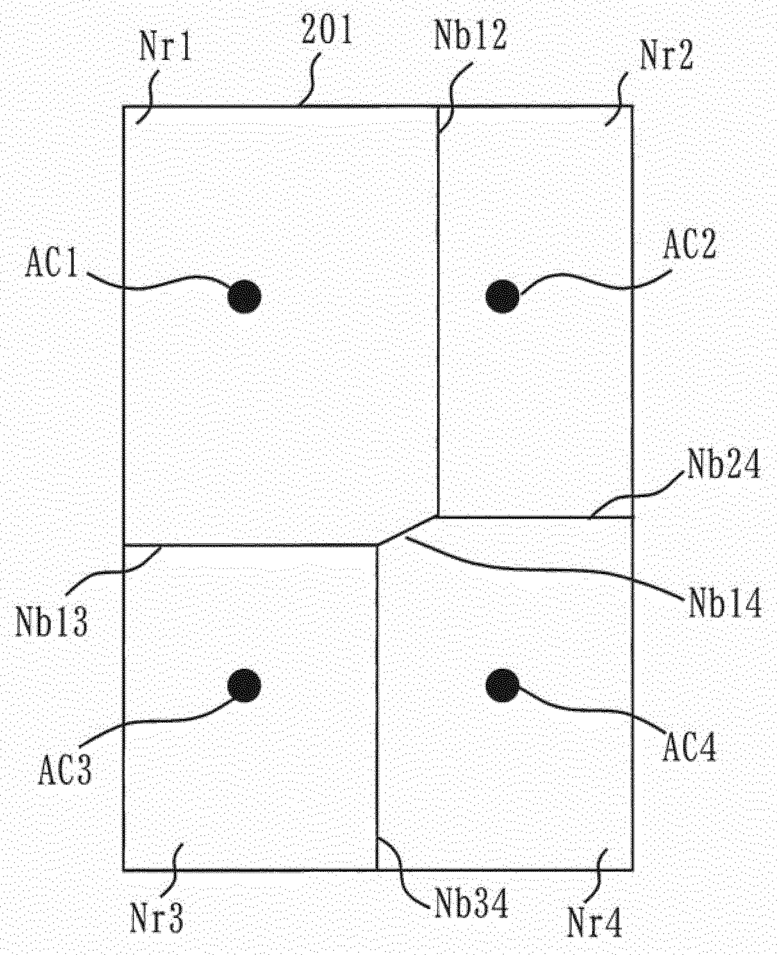

Fig. 11

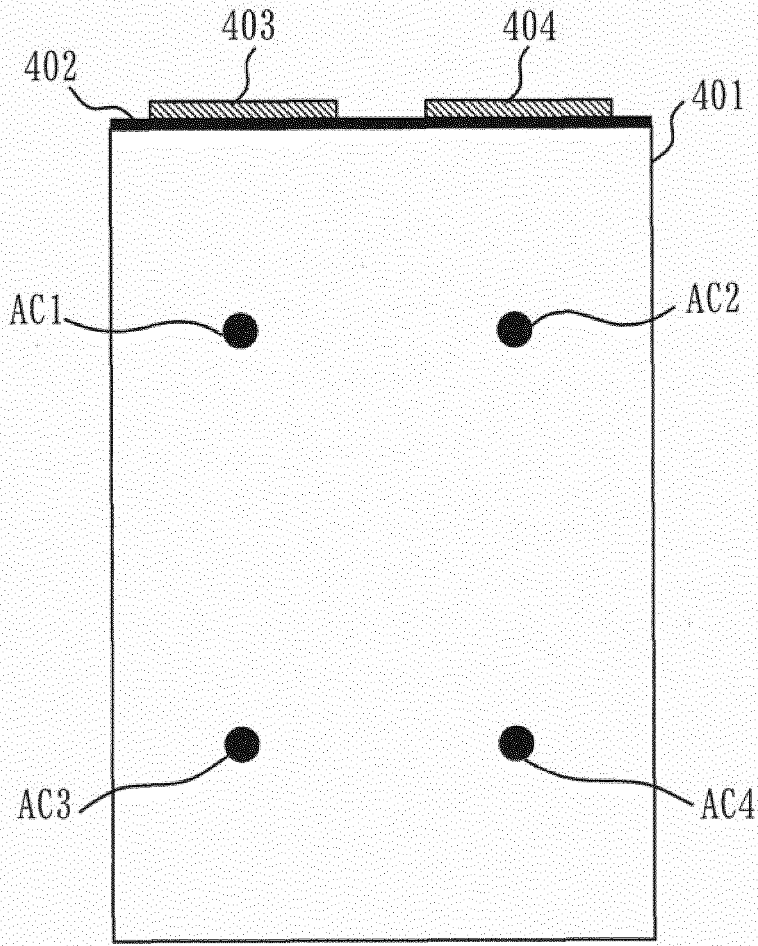

Fig. 12

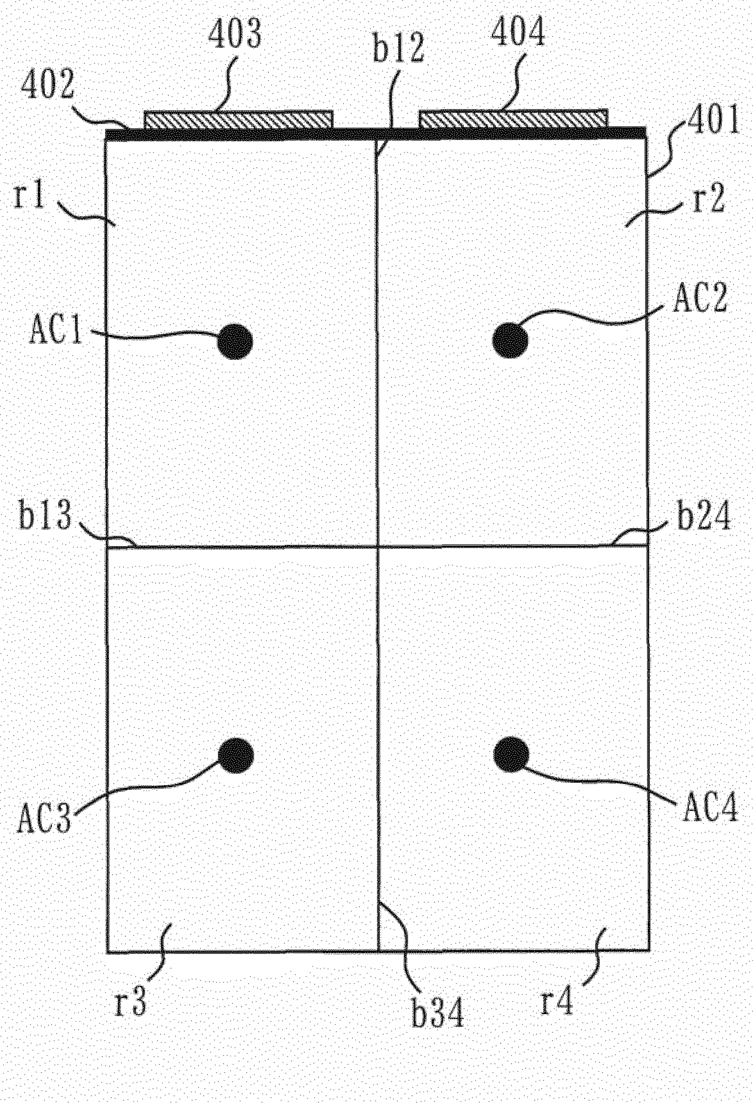

Fig. 13

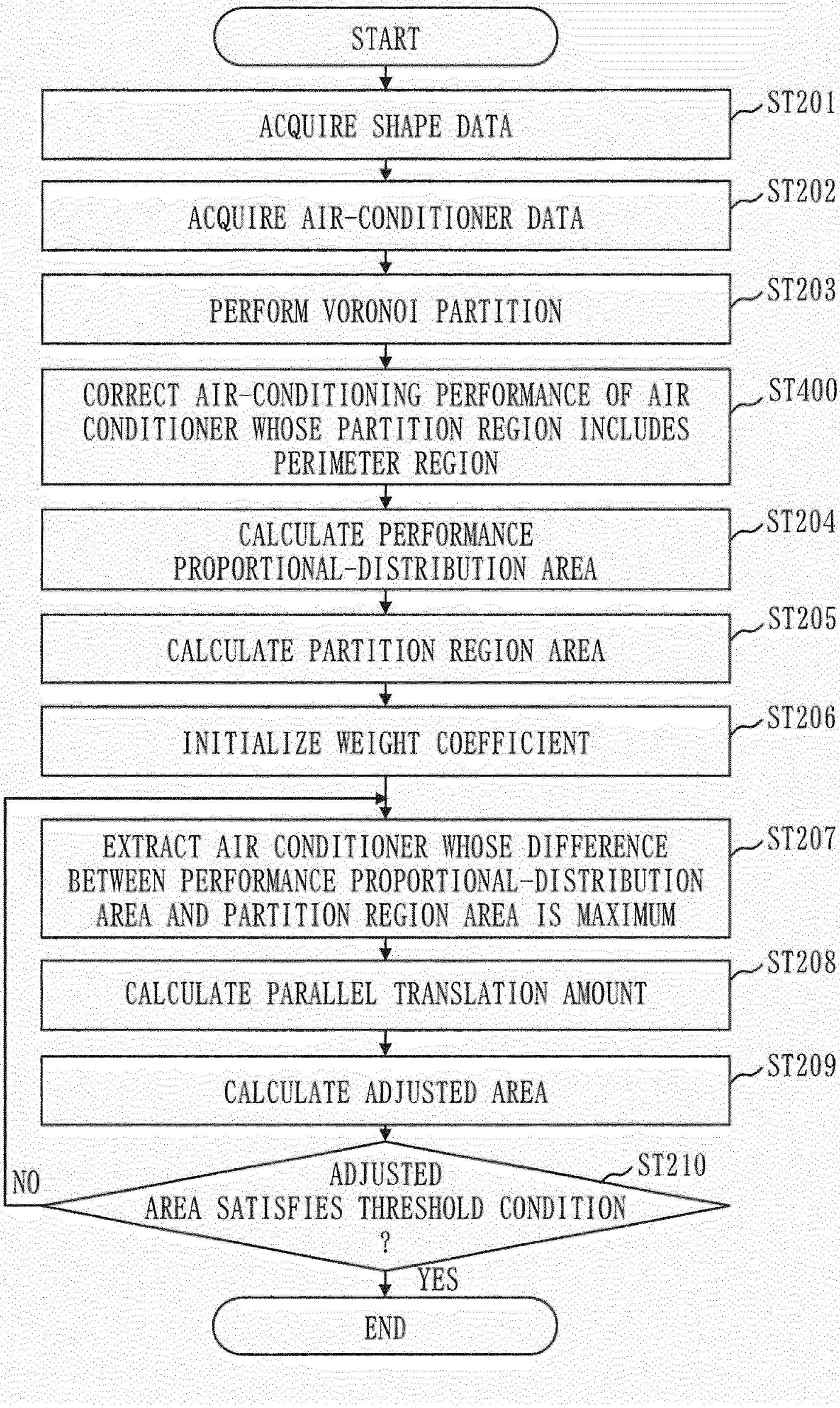
START
ACQUIRE SHAPE DATA
ST201
ACQUIRE AIR-CONDITIONER DATA
ST202
PERFORM VORONOI PARTITION
ST203
CORRECT AIR-CONDITIONING PERFORMANCE OF AIR CONDITIONER WHOSE PARTITION REGION INCLUDES PERIMETER REGION
ST400
CALCULATE PERFORMANCE PROPORTIONAL-DISTRIBUTION AREA
ST204
CALCULATE PARTITION REGION AREA
ST205
INITIALIZE WEIGHT COEFFICIENT
ST206
EXTRACT AIR CONDITIONER WHOSE DIFFERENCE BETWEEN PERFORMANCE PROPORTIONAL-DISTRIBUTION AREA AND PARTITION REGION AREA IS MAXIMUM
ST207
CALCULATE PARALLEL TRANSLATION AMOUNT
ST208
CALCULATE ADJUSTED AREA
ST209
ADJUSTED AREA SATISFIES THRESHOLD CONDITION ?
ST210
NO
YES
END

Fig. 14

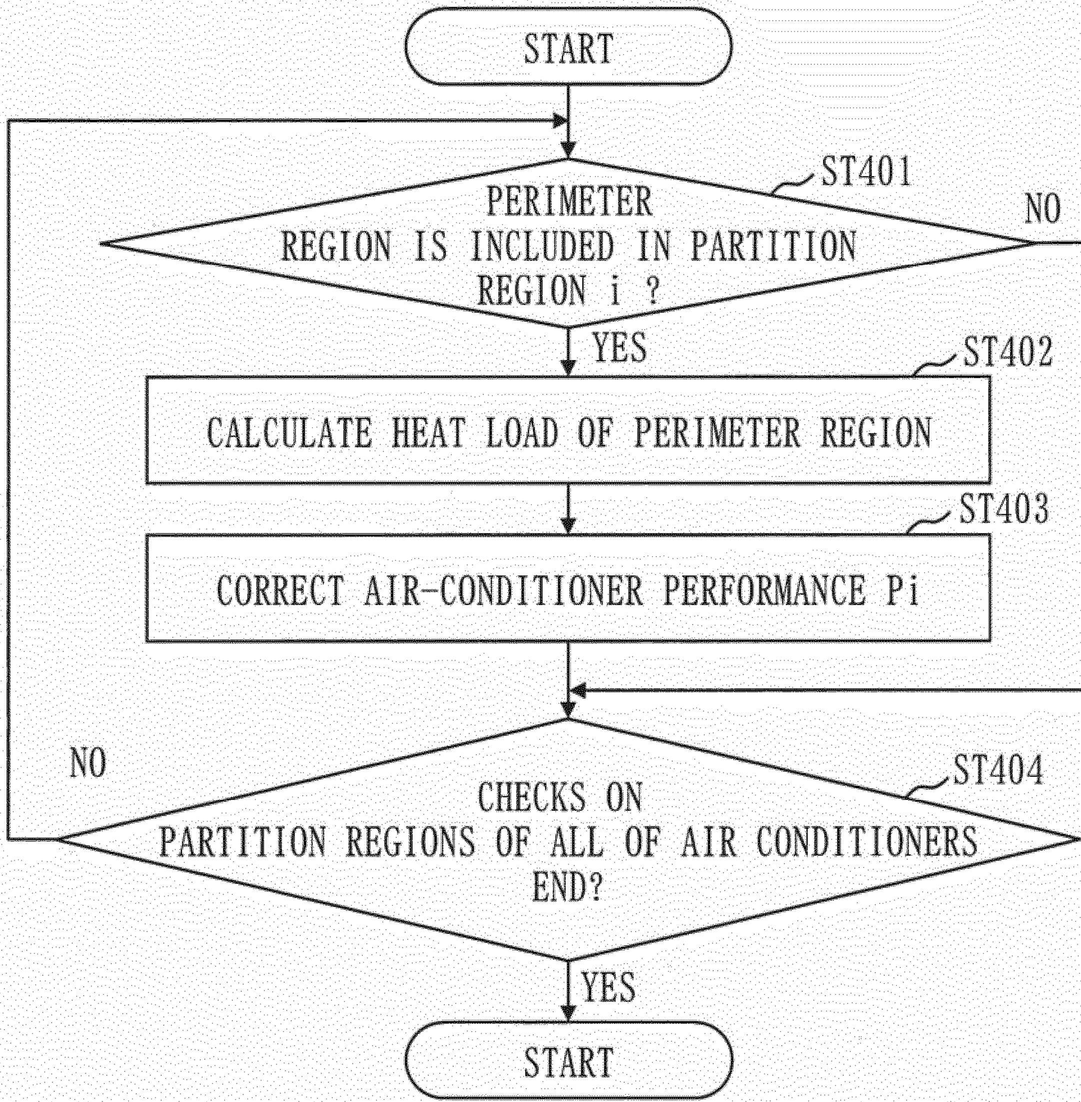
START
ST401
PERIMETER REGION IS INCLUDED IN PARTITION REGION i ?
NO
YES
ST402
CALCULATE HEAT LOAD OF PERIMETER REGION
ST403
CORRECT AIR-CONDITIONER PERFORMANCE Pi
NO
ST404
CHECKS ON PARTITION REGIONS OF ALL OF AIR CONDITIONERS END?
YES
START

## INTERNATIONAL SEARCH REPORT

International application No.
PCT/JP2020/001492

A. CLASSIFICATION OF SUBJECT MATTER
Int. Cl. F24F11/63(2018.01)i
FI: F24F11/63

According to International Patent Classification (IPC) or to both national classification and IPC

B. FIELDS SEARCHED

Minimum documentation searched (classification system followed by classification symbols)
Int. Cl. F24F

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2017/046875 A1 (TOSHIBA CORP.) 23 March 2017, entire text, all drawings | 1-10 |
| A | US 2011/0218773 A1 (INTERNATIONAL BUSINESS MACHINES CORPORATION) 08 September 2011, entire text, all drawings | 1-10 |
| A | JP 2008-75973 A (TOSHIBA CORP.) 03 April 2008, entire text, all drawings | 1-10 |
| A | JP 2007-285542 A (HITACHI APPLIANCES, INC.) 01 November 2007, entire text, all drawings | 1-10 |

☐ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 14.02.2020 | 25.02.2020 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2020/001492

| Patent Documents referred to in the Report | Publication Date | Patent Family | Publication Date |
|---|---|---|---|
| WO 2017/046875 A1 | 23.03.2017 | US 2018/0011950 A1<br>GB 2552281 A<br>CN 107408139 A | |
| US 2011/0218773 A1 | 08.09.2011 | (Family: none) | |
| JP 2008-75973 A | 03.04.2008 | (Family: none) | |
| JP 2007-285542 A | 01.11.2007 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2017212563 A
- WO 2017046875 A